# EUROPEAN PATENT APPLICATION

(11) **EP 4 734 738 A1**
(43) Date of publication of application: **29.04.2026**
(21) Application number: 25197142.0
(22) Date of filing: 20.08.2025
(51) Int. Cl.: H10P 72/00, H10P 72/50, H10P 72/76

(54) **GRID HANDLING LOAD LOCK DOOR FOR POSITIONAL REPEATABILITY**

(30) Priority: 20.08.2024 US 202418809710
(71) Applicant: FEI Company, Hillsboro, OR 97124 (US)
(72) Inventor: SMITH, Simon-Pierre, Hillsboro (US); ALAMEDA DE LA MORA, Esau, Hillsboro (US); KIM, Jae Hong, Lake Oswego (US); NEELY, Ronald Edward, Hillsboro (US); MORGAN, Glenn Aaron, Cornelius (US)
(74) Representative: Boult Wade Tennant LLP

(57) **Abstract**

Embodiments described herein relate to systems and/or methods for providing positional repeatability of closure of an opening of a scientific instrument and/or of alignment of samples relative to a coordinate system of the scientific instrument. A system can comprise a retaining member that receives a sample support cartridge, a first portion of a kinematic coupling that receives a second portion of a kinematic coupling, and the second portion of the kinematic coupling disposed at the retaining member, wherein at least the first portion of the kinematic coupling or the second portion of the kinematic coupling is disposed for joint movement with the sample support cartridge when coupled to the retaining member. A system can comprise a vacuum chamber body, a vacuum chamber door, and a kinematic coupling providing for adjustable alignment of a sample support cartridge at the vacuum chamber door relative to the vacuum chamber body.

## Description

### BACKGROUND

Scientific imaging devices can provide for high-magnification used to obtain high-resolution images of specimens through employment of focused energy beams or charged particles, careful sample preparation, controlled conditions, and/or specialized computer systems. Successful provision of each of these aspects, and thus successful output of a high-information, accurate images of samples, can rely upon accurate, precise and/or repeatable sample provision, including sample locating and/or sample alignment relative to one or more movable elements and/or imaging elements of a scientific imaging device.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 illustrates a block diagram of an example scientific instrument for performing one or more operations, in combination with a non-limiting sample positioning system, in accordance with one or more embodiments described herein.
FIG. 2 illustrates a graphical user interface (GUI) that can be used in the performance of one or more of the methods described herein, in accordance with one or more embodiments described herein.
FIG. 3 illustrates a block diagram of an example computing device that can perform one or more of the methods disclosed herein, in accordance with one or more embodiments described herein.
FIG. 4 illustrates a partial, schematic overhead view of a chamber door assembly, as described herein, in use with the example scientific instrument of FIG. 1, in accordance with one or more embodiments described herein.
FIG. 5 illustrates partial, schematic, chamber-facing side view of the chamber door assembly of FIG. 4, in accordance with one or more embodiments described herein.
FIG. 6 illustrates a partial overhead view of a sample positioning system, including the chamber door assembly of FIG. 4, in use with the example scientific instrument of FIG. 1, in accordance with one or more embodiments described herein.
FIG. 7 illustrates a partial overhead view of a chamber-facing side view of the sample positioning system of FIG. 6, including the chamber door assembly of FIG. 4 and including a sample support assembly, in use with the example scientific instrument of FIG. 1, in accordance with one or more embodiments described herein.
FIG. 8 illustrates an orthogonal view of a grid holder, for use in carrying lamella for positioning within the scientific instrument of FIG. 1, in accordance with one or more embodiments described herein.
FIG. 9 illustrates an orthogonal, chamber-facing side view of the sample support assembly of FIG. 7, for use in retaining and positioning a set of grid holders of FIG. 8 external to and internal to the scientific instrument of FIG. 1, in accordance with one or more embodiments described herein.
FIG. 10 illustrates an orthogonal, external door-facing side view of the sample support assembly of FIG. 9, for use in retaining and positioning a set of one or more grid holders of FIG. 8 external to and internal to the scientific instrument of FIG. 1, in accordance with one or more embodiments described herein.
FIG. 11 illustrates an orthogonal, overhead, front view of the sample support assembly of FIG. 9 with components thereof spaced apart from one another, in accordance with one or more embodiments described herein.
FIG. 12 illustrates an orthogonal overhead, front view of a sample support cartridge of the sample support assembly of FIG. 9, and an orthogonal bottom view of the sample support cartridge, in accordance with one or more embodiments described herein.
FIG. 13 illustrates an orthogonal, overhead, front view of a position adjuster of the sample support assembly of FIG. 9, in accordance with one or more embodiments described herein.
FIG. 14 illustrates an orthogonal, overhead, front view of a flex adjuster of the sample support assembly of FIG. 9, in accordance with one or more embodiments described herein.
FIG. 15 illustrates a flow diagram of a method of use of a sample positioning system described herein, in accordance with one or more embodiments described herein.
FIG. 16 illustrates a flow diagram of another method of use of a sample positioning system described herein, in accordance with one or more embodiments described herein.
FIG. 17 illustrates a continuation of the flow diagram of FIG. 16 of a method of use of a sample positioning system described herein, in accordance with one or more embodiments described herein.
FIG. 18 illustrates a block diagram of example scientific instrument system within which a system described herein can be incorporated, in accordance with one or more embodiments described herein.
FIG. 19 illustrates a block diagram of an example operating environment with which embodiments of the subject matter described herein can be incorporated.
FIG. 20 illustrates an example schematic block diagram of a computing environment with which the subject matter described herein can interact and/or be implemented at least in part.

### SUMMARY

The following presents a summary to provide a basic understanding of one or more embodiments described herein. This summary is not intended to identify key or critical elements, and/or to delineate scope of particular embodiments or scope of claims. Its sole purpose is to present concepts in a simplified form as a prelude to the more detailed description that is presented later. In one or more embodiments, one or more systems, apparatuses and/or methods described herein can provide accurate, precise and/or repeatable sample positioning for a scientific instrument, such as a scientific imaging system.

In accordance with an embodiment, a scientific instrument can comprise a retaining member that receives a sample support cartridge, a first portion of a kinematic coupling that receives a second portion of a kinematic coupling, and the second portion of the kinematic coupling disposed at the retaining member, wherein at least the first portion of the kinematic coupling or the second portion of the kinematic coupling is disposed for joint movement with the sample support cartridge when coupled to the retaining member.

In accordance with another embodiment, a scientific instrument can comprise a vacuum chamber body, a vacuum chamber door, and a kinematic coupling providing for adjustable alignment of a sample support cartridge at the vacuum chamber door relative to the vacuum chamber body.

In accordance with still another embodiment, a method can comprise kinematically coupling a sample support cartridge to a retaining member, and kinematically aligning the retaining member against a base unit using a kinematic coupling having a shape that allows for adjustability of the retaining member relative to the base unit while the kinematic coupling is engaged.

The one or more embodiments described herein can be implemented within, in connection with and/or coupled to a scientific imaging device.

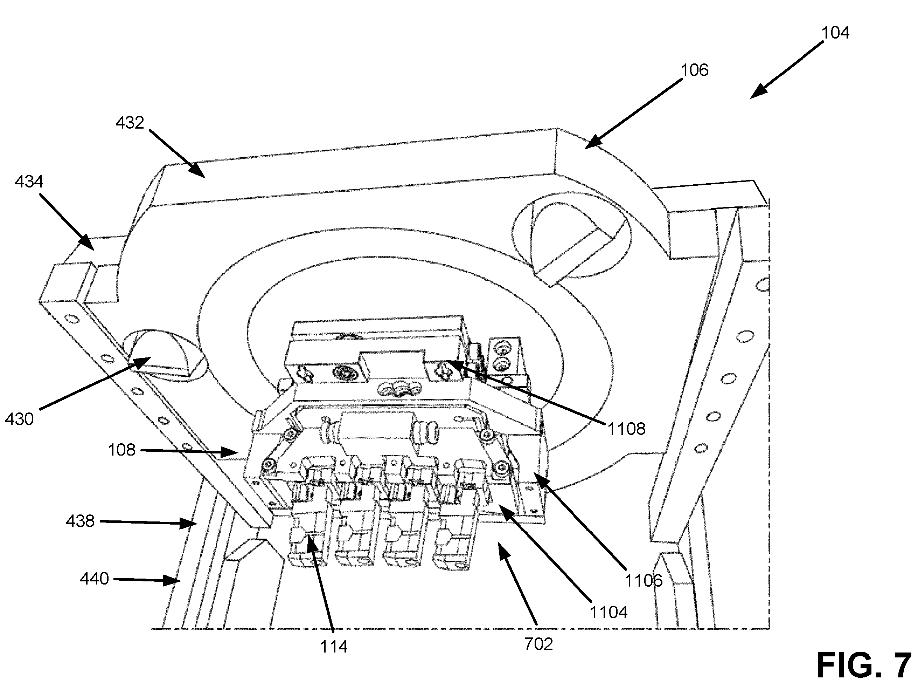

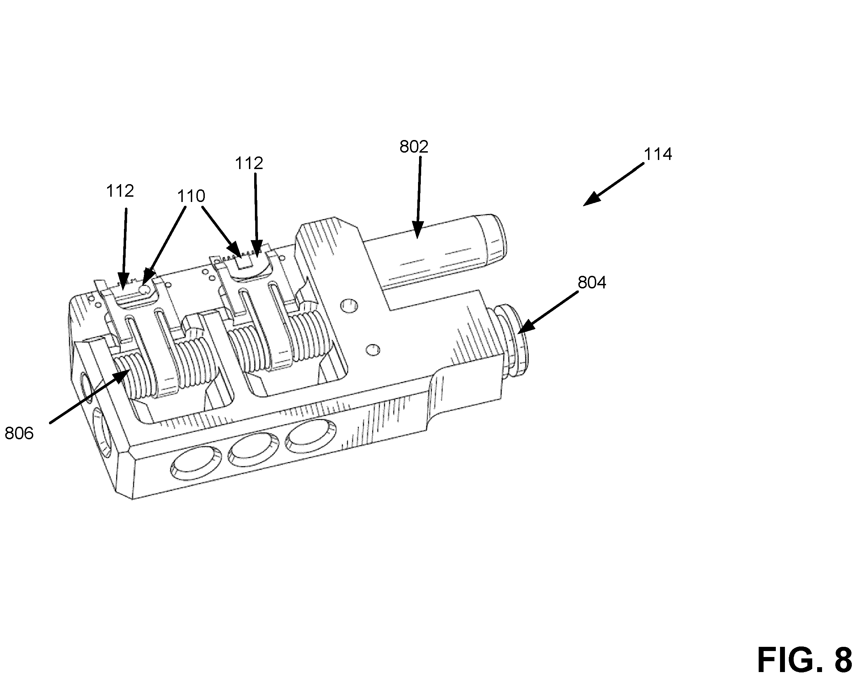

The one or more embodiments described herein can provide for at least four degrees of freedom of adjustment of a grid holder (e.g., grid holder 114 at FIGS. 7 and/or 8) or other grid receiving element of the one or more embodiments, such as relative to a chamber body (e.g., chamber structure) of a scientific instrument and/or robotic element coordinate system of the scientific instrument. These degrees of freedom can be addressed at least partially separately, through use of different elements of the systems and/or assemblies described herein such as to allow for adjustment of pairs of, individual, and/or discrete degrees of freedom without affecting one or more other degrees of freedom.

In one or more cases, such adjustment can be employed after coupling of a grid holder to the one or more embodiments described herein. In one or more cases, at least a portion of such adjustment can be made before coupling of the sample support cartridge to the one or more embodiments. In one or more cases, at least a portion of such adjustment can be made after coupling of the sample support cartridge to the one or more embodiments.

In one or more cases, this adjustment can allow for low micron alignment (e.g., about 1 micron or about 2 micron) without the use of shims, and thus can provide for low micron repeatability of positioning. In turn, this can allow for execution of experiments and/or imaging based on repeatable setups, compliance with scientific standards, and/or reduction in subjective user positioning error. Existing frameworks can fail to provide even a level of one or two microns of positional repeatability.

Indeed, in one or more cases, use of the one or more embodiments described herein can reduce and/or fully negate use of shims to adjust position of a grid holder or receiver element for a grid holder. This can allow for significant reduction in setup time for use of a scientific instrument, such as in the order of 50% or more reduction in setup time as compared to existing sample alignment frameworks, devices, apparatuses, systems and/or methods.

The one or more embodiments can provide for repeatable adjustability of the systems and/or assemblies described herein and can allow for sealing with, and/or alignment relative to, a flexible sealing element between the one or more embodiments and a chamber body of a scientific instrument. This can allow for addressing, such as moving of a chamber door assembly relative to, different sealing member profiles caused by compression of the sealing member, without affecting vacuum seal of a respective chamber being sealed by the chamber door assembly of a sample positioning system described herein.

The one or more embodiments described herein can be assembled in a compact form, allowing for minimal use of real estate within a chamber of a scientific instrument.

### DETAILED DESCRIPTION

The following detailed description is merely illustrative and is not intended to limit embodiments and/or application or utilization of embodiments. Furthermore, there is no intention to be bound by any expressed or implied information presented in the preceding Summary section, or in the Detailed Description section. One or more embodiments are now described with reference to the drawings, wherein like reference numerals are utilized to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

Various operations can be described as multiple discrete actions or operations in turn, in a manner that is most helpful in understanding the subject matter disclosed herein. However, the order of description should not be construed as to imply that these operations are necessarily order dependent. In particular, these operations can be performed in an order different from the order of presentation. Operations described can be performed in a different order from the described embodiment. Various additional operations can be performed, and/or described operations can be omitted in additional embodiments.

Turning now to the subject of sample positioning for scientific instruments, such positioning can be important for instrument setup, compliance, positional repeatability, positional accuracy and/or precision, robotic sample handling, increased throughput of samples, and/or vacuum sealing of an instrument opening, without being limited thereto.

In a vacuum chamber application, particularly when there is a moving part to be sealed, an elastic member, such as an o-ring seal or other compliant material, can be employed to provide sealing. With existing frameworks, positioning issues, such as a positional repeatability issue, can arise when an elastic sealing member (e.g., an o-ring seal) is employed in a kinematic coupling application for which high repeatability is desired. This can result due to friction created by the elastic sealing member, variations in size of different elastic sealing members, change in compressed profiles of elastic sealing members over time, etc., thus preventing a pair of mating surfaces from sliding against one another easily. In turn, this can result in poor repeatability of alignment of the pair of mating surfaces relative to one another. This in turn can affect alignment of a sample or sample holder relative to a coordinate system, movable point and/or fixed point within the vacuum chamber being sealed.

Additionally, and/or alternatively, sample alignment can be affected in existing systems through use of shims to accurately align samples relative to a coordinate system or other point within a scientific instrument chamber. This can be because shimming can be both subjective and cause movement of an element in plural degrees of freedom at a same time. Thus, one shim can eliminate and/or modify the shimming providing by another previous shim, and so on and so forth.

Additionally, and/or alternatively, sample transfer between environment side/air side (external to a chamber of a scientific instrument) and vacuum side (within a chamber of a scientific instrument) of a scientific instrument is greatly throughput-limited in existing frameworks. This can be at least partially due to strict positional accuracy specifications for alignment of samples at an element, such as a chamber door assembly, at the air side, prior to insertion of the samples into the vacuum side. In one or more cases, such strict positional accuracy specifications can be due at least in part to use of a sample handling robot, or other automated sample handling element, within the scientific instrument (e.g., at the vacuum side).

For example, a workflow executed by a scientific instrument can comprise transfer of grids from a loading station, such as a sample support assembly at a chamber door assembly and/or of a sample positioning system. Transfer can be achieved by the sample handling robot or other automated sample handling element in the vacuum environment (e.g., at the vacuum side), with transfer being back and forth between the loading station and a wafer holder, such as at a stage of the scientific instrument. The sample handling robot or other automated sample handling element can have limited adjustability. Thus, alignment of a sample relative to a coordinate system of the sample handling robot or other automated sample handling element can allow for successful transfer of the sample, while misalignment relative to the coordinate system can lead to sample transfer failure. Failure can comprise inability to obtain a sample, sample grid or grid holder and/or misalignment thereof, causing dropping of the sample, sample grid or grid holder and/or misalignment at the wafer holder.

Additionally, and/or alternatively, sample throughput can be limited by an amount of samples that can be loaded at a sample support assembly, such as where samples are loaded to the sample positioning system. In such case, time between sample analysis cycles can be long due to removal of samples from the sample positioning system and/or from within the chamber in existing frameworks, re-preparation of one or more sample holders that were used in a previous cycle, and subsequent re-loading of the one or more sample holders. This can be compounded by the time to vent/evacuate the vacuum side to allow for opening of the instrument vacuum chamber using the sample positioning system, which evacuation generally can be a fixed time period. For example, in one or more cases, each evacuation cycle can take about 200 minutes or more, such as about 3.5 hours.

To account for one or more deficiencies of such existing frameworks, one or more embodiments are described herein that can provide increase of accuracy and/or efficiency of alignment of sample grids, and/or increase in sample throughput of samples, for use with a scientific instrument. Additionally, and/or alternatively, the one or more embodiments described herein can provide increase in flexibility of adjustment of a scientific instrument door relative to a sealing member and/or independent adjustment of individual degrees of freedom, separate from one another, of a sample cartridge (and thus of a sample grid carried by the sample cartridge) relative to any other aspect of the scientific instrument and/or one or more embodiments described herein.

That is, generally, the one or more embodiments described herein can provide for kinematically coupling a sample support cartridge to a retaining member, and kinematically aligning the retaining member against a base unit using a kinematic coupling having a shape that allows for adjustability of the retaining member relative to the base unit while the kinematic coupling is engaged. It will be appreciated that, as described below, both the position adjuster of the sample support assembly and the door of the chamber door assembly can be described as a retaining member having these features.

In another one or more embodiments, a sample positioning system can comprise both a chamber door assembly and a sample support assembly, that can be coupled to the chamber door assembly, for joint movement with the chamber door assembly.

The chamber door assembly can comprise at least a pair of components, wherein at least one of these components can have degrees of freedom, such as three degrees of freedom, or such as four degrees of freedom, of adjustment relative to the other component of the pair of components. At least one or more of such degrees of freedom can be adjusted independently of others of the degrees of freedom.

At least one of the components can comprise one aspect of a kinematic coupling while another mating aspect of the kinematic coupling can be employed at a chamber body of a scientific instrument, such as an imaging device. In one or more cases, a kinematic coupling can provide one or more degrees of freedom. In one or more embodiments, a first kinematic coupling can be employed between first and second components and a second kinematic coupling can be employed between third and fourth components.

The degrees of freedom can allow for adjustment of the chamber door assembly relative to an elastic sealing element when aligning the chamber door assembly relative to the chamber body. The degrees of freedom additionally, and/or alternatively, can allow for adjustment of a sample support assembly, when coupled to the chamber door assembly, relative to the chamber body.

The sample support assembly can be comprised of a pair of adjustment components and a sample support cartridge. These adjustment components and sample support cartridge together can be assembled into a compact body that can fill limited real estate (e.g., space) at a vacuum side of a scientific instrument. Together, the three components of the sample support assembly can provide for at least five different degrees of freedom.

The sample support cartridge can be swappable, to allow for another sample support cartridge to replace a sample support cartridge removed from a vacuum side environment. In this way, the new sample support cartridge can be pre-loaded with samples (e.g., lamella) on lamella carriers of grid holders coupled to the sample support cartridge. This can allow for a significant increase in sample throughput at a scientific instrument using the sample support assembly. That is, there is no wait for removal of used samples from individual grid holders and/or re-preparation of immediately previously used lamella carriers. Rather, these processes can be performed separately from the sample support assembly and separate from re-use (e.g., operation of another cycle) of the respective scientific instrument.

The pair of adjustment components can be configured to provide independent and distinct degrees of freedom relative to one another. In this way, one or more degrees of freedom can be adjusted independently without affecting positioning relative to one or more other degrees of freedom. This benefit cannot be provided by existing frameworks.

The one or more embodiments disclosed herein can achieve improved performance relative to existing approaches, as noted above. For example, one or more benefits of the above-noted systems and/or assemblies can comprise an ability to provide one or more adjustments of a sample support cartridge, such as via the one or more degrees of freedom of the sample support assembly or of the chamber door assembly, when the sample positioning system is assembled but not fully fixedly coupled. Likewise, at least one of the components of the chamber door assembly can be adjusted in this same manner, when coupled together, relative to the other component of the chamber door assembly. Likewise, at least one of the three components of the sample support assembly can be adjusted in this manner, when coupled together, relative to the other component of the sample support assembly.

Various ones of the embodiments disclosed herein can improve upon existing approaches to achieve the technical advantages of high adjustability and/or accurate positional repeatability. For example, using the above-noted configured adjustabilities, the sample support assembly, chamber door assembly, and sample positioning system each can provide for low micron adjustment, using independent adjustment of discrete degrees of freedom, which cannot be provided by existing frameworks. Indeed, this can allow for repeatable setups of samples relative to a coordinate system of a chamber body (e.g., of a robotic element in/of the chamber body). Furthermore, one or more of these aspects can provide for reduction and/or negation of use of shims for alignment, addressing of subjective alignments by providing greater flexibility, and/or reduction in time to prepare an instrument system (e.g., starting with evacuation of the respective vacuum chamber if included in the instrument system). These can be useful processes for varying industries employing material analysis, sample imaging, product manufacturing, quality control and/or the like.

The technical features of the embodiments disclosed herein (e.g., high adjustability and/or accurate positional repeatability) are decidedly unconventional in the manner described herein, in the field of material analysis, in addition to the fields of optics, signal processing, spectroscopy, and/or NMR, without being limited thereto, as are various combinations of the features of the embodiments disclosed herein.

The one or more embodiments described herein can be employed with a plurality of different scientific instruments that can be operated for analysis, evaluation, imaging, sample preparation and/or sample modification, without being limited thereto, of samples that can be loaded, moved and/or adjusted using the sample support assembly, chamber door assembly, and/or sample positioning system described herein. While discussion is provided below of use relative to a vacuum chamber body and/or load lock chamber body, the chamber need not be able to be vacuumed. Rather, other chamber types can be employed with the one or more embodiments described herein, such as a non-vacuum chamber. That is, the positional adjustment and/or repeatability provided by the one or more embodiments described herein can be applicable to any one or more of the types of scientific instruments noted herein, without being limited thereto.

The embodiments disclosed herein thus can provide improvements to scientific instrument technology (e.g., improvements in such scientific instruments, among other improvements), which can be employed for sample analysis in various fields including optics, signal processing, spectroscopy, and/or nuclear magnetic resonance (NMR), without being limited thereto.

Indeed, based on the above general descriptions of the one or more embodiments described herein, the present disclosure thus introduces functionality that neither an existing framework device, nor a human alone, could perform. Rather, such existing frameworks are ineffective at low micron repeatable adjustment relative to an elastomer sealing member and/or relative to a coordinate system of a scientific instrument, are ineffective at providing for adjustment of separate degrees of freedom absent affect one or more other degrees of freedom, and further are unable to provide the sample throughput that can be achieved using the one or more embodiments described herein. Accordingly, in view of the extensive setup time and/or loss of sample positional accuracy, precision and/or repeatability associated with existing approaches, it is not practical to operate within the confines of existing approaches.

Accordingly, the embodiments of the present disclosure can be employed with a scientific instrument having any one or more of a number of technical purposes, such as controlling a specific technical system or process; determining from measurements how to control a machine; digital audio, image, or video enhancement or analysis; separation of material sources in a mixed signal; generating data for reliable and/or efficient transmission or storage; providing estimates and confidence intervals for material samples; and/or providing a faster processing of sensor data.

The embodiments disclosed herein thus provide improvements to material analysis technology (e.g., improvements in the sample preparation, arrangement, provision and/or positioning relative to scientific instruments for material analysis, among other improvements).

As used herein, the phrase "based on" should be understood to mean "based at least in part on," unless otherwise specified.

As used herein, the term "data" can comprise metadata.

As used herein, the terms "entity," "requesting entity," and "user entity" can refer to a machine, device, component, hardware, software, smart device, party, organization, individual and/or human.

As used herein, the term "sample" can refer to a single material, multiple materials, compound, composition, lamella, solution, product, etc.

One or more embodiments are now described with reference to the drawings, where like referenced numerals are used to refer to like drawing elements throughout. In the following description, for purposes of explanation, numerous specific details are set forth in order to provide a more thorough understanding of the one or more embodiments. It is evident in various cases, however, that the one or more embodiments can be practiced without these specific details.

Further, it should be appreciated that the embodiments depicted in one or more figures described herein are for illustration only, and as such, the architecture of embodiments is not limited to the systems, devices and/or components depicted therein, nor to any particular order, connection and/or coupling of systems, devices and/or components depicted therein.

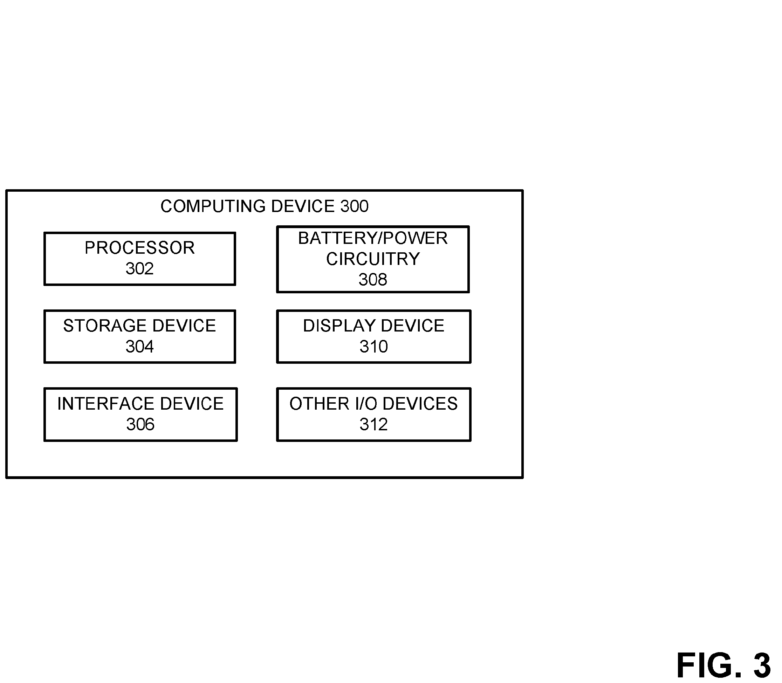

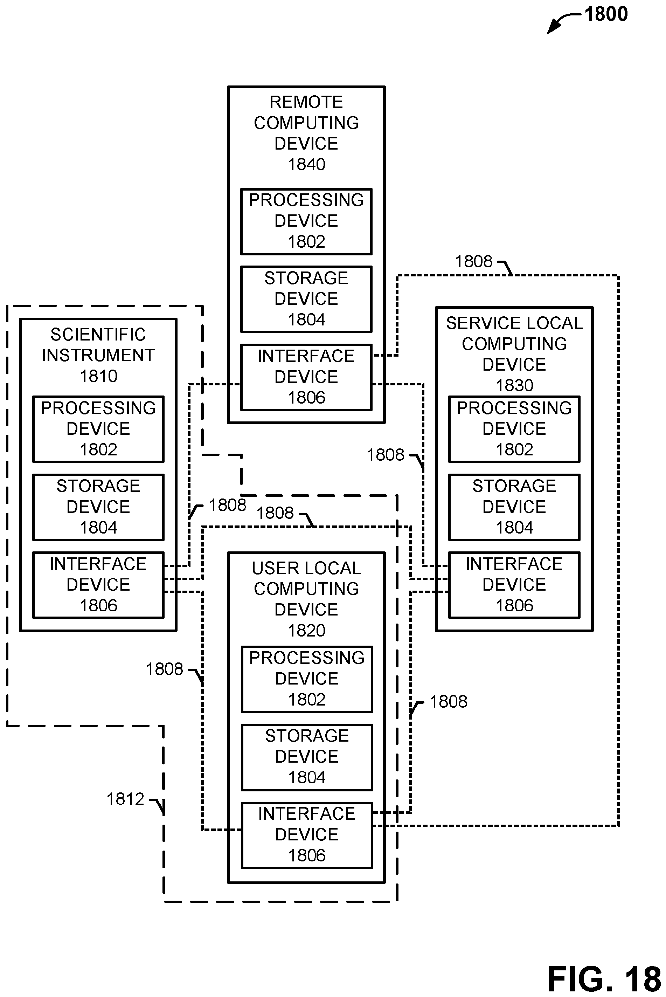

The scientific instrument methods disclosed herein can be employed with and/or be comprised by one or more scientific instruments that can execute interactions with a user entity (e.g., via the user local computing device 1820 discussed herein with reference to FIG. 18). These interactions can include providing information to the user entity (e.g., information regarding the operation of a scientific instrument such as the scientific instrument 1810 of FIG. 18, information regarding a sample being analyzed or other test or measurement performed by a scientific instrument, information retrieved from a local or remote database, or other information) or providing an option for a user entity to input commands (e.g., to control the operation of a scientific instrument such as the scientific instrument 1810 of FIG. 18, or to control the analysis of data generated by a scientific instrument), queries (e.g., to a local or remote database), or other information. In some embodiments, these interactions can be performed through a graphical user interface (GUI) that includes a visual display on a display device (e.g., the display device 310 discussed herein with reference to FIG. 3) that provides outputs to the user entity and/or prompts the user entity to provide inputs (e.g., via one or more input devices, such as a keyboard, mouse, trackpad, or touchscreen, included in the other I/O devices 312 discussed herein with reference to FIG. 3). The scientific instrument system 1800 disclosed herein can include any suitable GUIs for interaction with a user entity.

Accordingly, discussion next turns to a general description of one or more scientific instrument systems that can comprise and/or be employed with the one or more embodiments described herein, as well as to related methods, computing devices, and/or computer-readable media, if suitable.

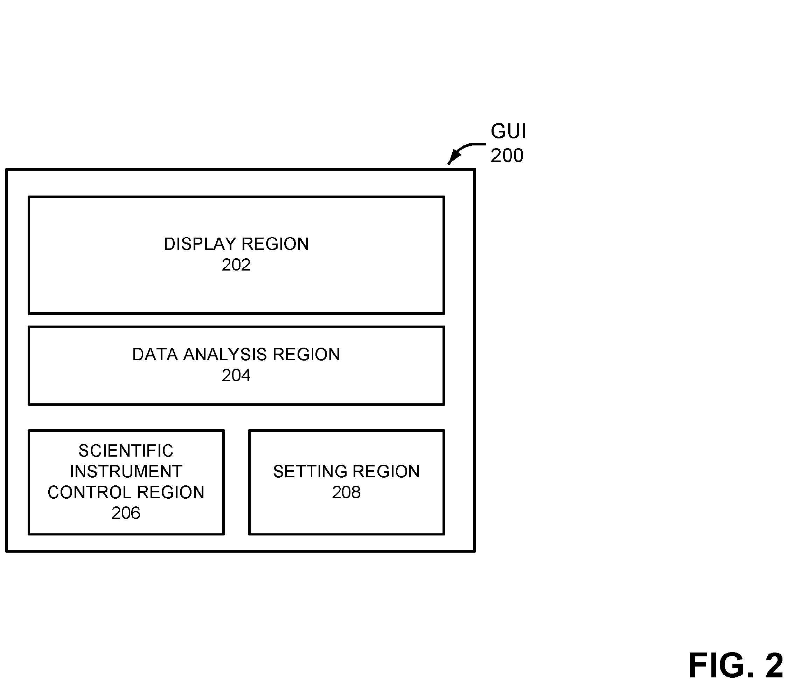

For example, turning first to FIG. 2, depicted is an example GUI 300 that can be used in the performance of one or more methods by such scientific instrument, such as in accordance with one or more of the various embodiments described herein. As noted above, the GUI 200 can be provided on a display device (e.g., the display device 310 discussed herein with reference to FIG. 3) of a computing device (e.g., the computing device 300 discussed herein with reference to FIG. 3) of a scientific instrument system (e.g., the scientific instrument system 1800 discussed herein with reference to FIG. 18), and a user entity can interact with the GUI 200 using any suitable input device (e.g., any of the input devices included in the other I/O devices 312 discussed herein with reference to FIG. 3) and input technique (e.g., movement of a cursor, motion capture, facial recognition, gesture detection, voice recognition, actuation of buttons, etc.).

The GUI 200 can include a data display region 202, a data analysis region 204, a scientific instrument control region 206, and a settings region 208. The particular number and arrangement of regions depicted in FIG. 2 is merely illustrative, and any number and arrangement of regions, including any desired features thereof, can be included in a GUI 200.

The data display region 202 can display data generated by a scientific instrument (e.g., the scientific instrument 1810 discussed herein with reference to FIG. 18). For example, the data display region 202 can display one or more output results which can comprise one or more spectra, one or more holographs, one or more digital images, etc., without being limited thereto.

The data analysis region 204 can display the results of data analysis (e.g., the results of analyzing the data illustrated in the data display region 202 and/or other data). For example, the data analysis region 204 can display one or more of the output results of an analysis of a sample positioned for the analysis using the one or more embodiments described herein. In one or more cases, the data analysis region 204 can display a list, flow chart or other schematic of acquisition actions taken and/or recommended relative to an experiment. In one or more embodiments, the data display region 202 and the data analysis region 204 can be combined in the GUI 200 (e.g., to include data output from a scientific instrument, and some analysis of the data, in a common graph or region).

The scientific instrument control region 206 can include options that can allow the user entity to control a scientific instrument (e.g., the scientific instrument 1810 discussed herein with reference to FIG. 18). For example, the scientific instrument control region 206 can include one or more controls for visualizing and/or moving a sample positioned by the one or more embodiments described herein.

The settings region 208 can include options that allow the user entity to control the features and functions of the GUI 200 (and/or other GUIs) and/or perform common computing operations with respect to the data display region 202 and data analysis region 204 (e.g., saving data on a storage device, such as the storage device 304 discussed herein with reference to FIG. 3, sending data to another user entity, labeling data, etc.).

Discussion next turns to FIG. 3, which illustrates a block diagram of a computing device 300 that can perform some or all of the scientific instrument methods disclosed herein, in accordance with various embodiments. In one or more embodiments, a scientific instrument that can employ the one or more embodiments described herein can be controlled by and/or comprise a single computing device 300 or multiple computing devices 300. Further, as discussed below, a computing device 300 (or multiple computing devices 300) can be part of one or more of the scientific instrument 1810, the user local computing device 1820, the service local computing device 1830, and/or the remote computing device 1840 of FIG. 18.

The computing device 300 of FIG. 3 is illustrated as having a number of components, but any one or more of these components can be omitted or duplicated, as suitable for the application and setting. As illustrated, these components can include one or more of a processor 302, storage device 304, interface device 306, battery/power circuitry 308, display device 310 and other input/output (I/O) devices 312, as will be described below.

In one or more embodiments, one or more of the components included in the computing device 300 can be attached to one or more motherboards and enclosed in a housing (e.g., including plastic, metal, and/or other materials). In one or more embodiments, some these components can be fabricated onto a single system-on-a-chip (SoC) (e.g., an SoC can include one or more processors 302 and one or more storage devices 304). Additionally, in one or more embodiments, the computing device 300 can omit one or more of the components illustrated in FIG. 3. In one or more embodiments, the computing device 300 can include interface circuitry (not shown) for coupling to the one or more components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface). For example, the computing device 300 can omit a display device 310, but can include display device interface circuitry (e.g., a connector and driver circuitry) to which a display device 310 can be coupled.

The computing device 300 can include the processor 302 (e.g., one or more processing devices). As used herein, the term "processing device" can refer to any device or portion of a device that processes electronic data from registers and/or memory to transform that electronic data into other electronic data that can be stored in registers and/or memory. The processor 302 can include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 300 can include a storage device 304 (e.g., one or more storage devices). The storage device 304 can include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solidstate memory devices, networked drives, cloud drives, or any combination of memory devices. In one or more embodiments, the storage device 304 can include memory that shares a die with a processor 302. In such an embodiment, the memory can be used as cache memory and can include embedded dynamic random-access memory (eDRAM) or spin transfer torque magnetic random-access memory (STT-MRAM), for example. In one or more embodiments, the storage device 304 can include non-transitory computer readable media having instructions thereon that, when executed by one or more processing devices (e.g., the processor 302), cause the computing device 300 to perform any appropriate ones of or portions of the methods disclosed herein.

The computing device 300 can include an interface device 306 (e.g., one or more interface devices 306). The interface device 306 can include one or more communication chips, connectors, and/or other hardware and software to govern communications between the computing device 300 and other computing devices. For example, the interface device 306 can include circuitry for managing wireless communications for the transfer of data to and from the computing device 300. The term "wireless" and its derivatives can be used to describe circuits, devices, systems, methods, techniques, communications channels, etc., that can communicate data through the use of modulated electromagnetic radiation through a nonsolid medium. The term does not imply that the associated devices do not contain any wires, although in one or more embodiments the associated devices might not contain any wires. Circuitry included in the interface device 306 for managing wireless communications can implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). In one or more embodiments, circuitry included in the interface device 306 for managing wireless communications can operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In one or more embodiments, circuitry included in the interface device 306 for managing wireless communications can operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In one or more embodiments, circuitry included in the interface device 306 for managing wireless communications can operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In one or more embodiments, the interface device 306 can include one or more antennas (e.g., one or more antenna arrays) to receipt and/or transmission of wireless communications.

One or more communications between one or more components of the computing device 300 and one or more components external to the computing device 300 can be provided by wired and/or wireless means including, but not limited to, employing a cellular network, a wide area network (WAN) (e.g., the Internet), and/or a local area network (LAN). Suitable wired or wireless technologies for supporting the communications can include, without being limited to, wireless fidelity (Wi-Fi), global system for mobile communications (GSM), universal mobile telecommunications system (UMTS), worldwide interoperability for microwave access (WiMAX), enhanced general packet radio service (enhanced GPRS), third generation partnership project (3GPP) long term evolution (LTE), third generation partnership project 2 (3GPP2) ultra-mobile broadband (UMB), high speed packet access (HSPA), Zigbee and other 802.XX wireless technologies and/or legacy telecommunication technologies, BLUETOOTH^{®}, Session Initiation Protocol (SIP), ZlGBEE^{®}, RF4CE protocol, WirelessHART protocol, 6LoWPAN (Ipv6 over Low power Wireless Area Networks), Z-Wave, an advanced and/or adaptive network technology (ANT), an ultra-wideband (UWB) standard protocol and/or other proprietary and/or non-proprietary communication protocols.

In one or more embodiments, the interface device 306 can include circuitry for managing wired communications, such as electrical, optical, or any other suitable communication protocols. For example, the interface device 306 can include circuitry to support communications in accordance with Ethernet technologies. In one or more embodiments, the interface device 306 can support both wireless and wired communication, and/or can support multiple wired communication protocols and/or multiple wireless communication protocols. For example, a first set of circuitry of the interface device 306 can be dedicated to shorter-range wireless communications such as Wi-Fi or Bluetooth, and a second set of circuitry of the interface device 306 can be dedicated to longer-range wireless communications such as global positioning system (GPS), EDGE, GPRS, CDMA, WiMAX, LTE, EV-DO, or others. In one or more embodiments, a first set of circuitry of the interface device 306 can be dedicated to wireless communications, and a second set of circuitry of the interface device 306 can be dedicated to wired communications.

The computing device 300 can include battery/power circuitry 308. The battery/power circuitry 308 can include one or more energy storage devices (e.g., batteries or capacitors) and/or circuitry for coupling components of the computing device 300 to an energy source separate from the computing device 300 (e.g., AC line power).

The computing device 300 can include a display device 310 (e.g., multiple display devices). The display device 310 can include any visual indicators, such as a heads-up display, a computer monitor, a projector, a touchscreen display, a liquid crystal display (LCD), a light-emitting diode display, or a flat panel display.

The computing device 300 can include other input/output (I/O) devices 312. The other I/O devices 312 can include one or more audio output devices (e.g., speakers, headsets, earbuds, alarms, etc.), one or more audio input devices (e.g., microphones or microphone arrays), location devices (e.g., GPS devices in communication with a satellite-based system to receive a location of the computing device 300, as known in the art), audio codecs, video codecs, printers, sensors (e.g., thermocouples or other temperature sensors, humidity sensors, pressure sensors, vibration sensors, accelerometers, gyroscopes, etc.), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 300 can have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultra mobile personal computer, etc.), a desktop computing device, or a server computing device or other networked computing component.

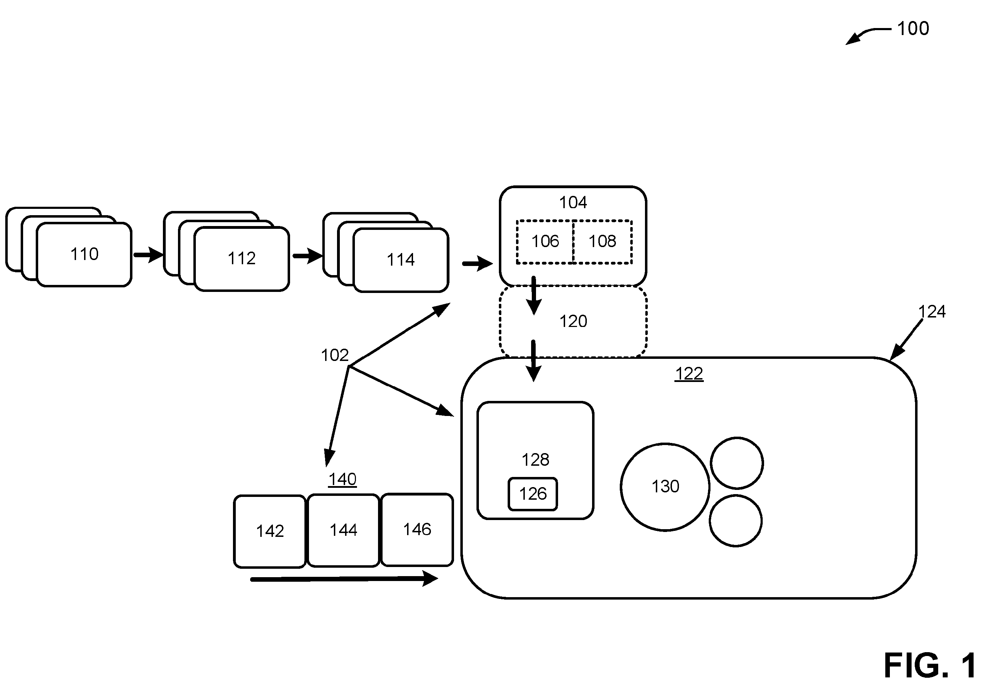

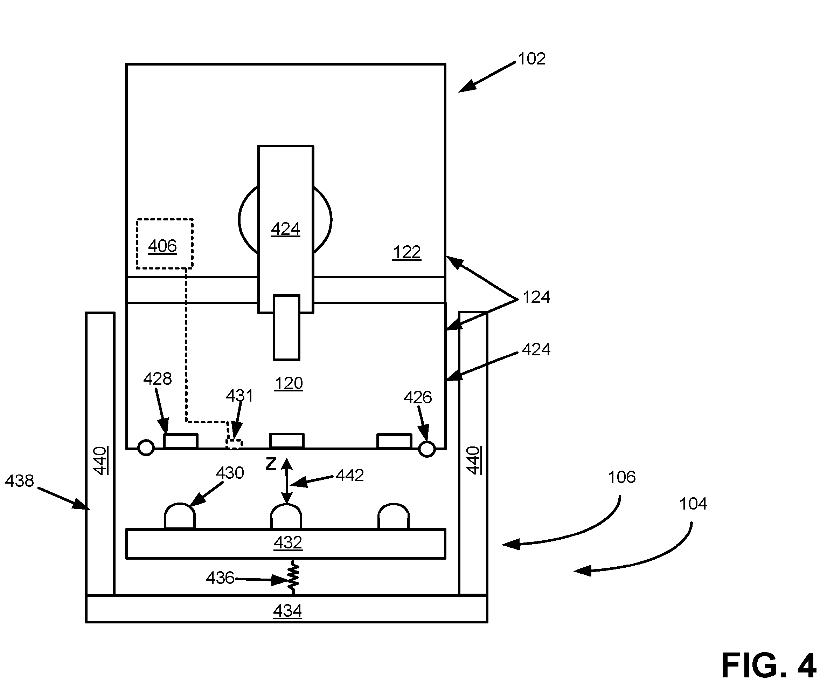

Referring now to FIG. 1, illustrated is a schematic diagram of a non-limiting system 100 comprising a scientific instrument 102 that can comprise and/or be employed with one or more systems and/or assemblies described herein, such as a sample positioning system 104, chamber door assembly 106 and/or sample support assembly 108 (e.g., where the sample positioning system 104 comprises the chamber door assembly 106 and/or the sample support assembly 108), to each be described below in detail relative to FIGS. 4 to 14. That is, the sample positioning system 104 can be considered to be comprised by the scientific instrument 102 and/or be separate from the scientific instrument 102. In either consideration, function of the sample positioning system 104 relative to the scientific instrument 102, and/or body structure thereof, can be the same.

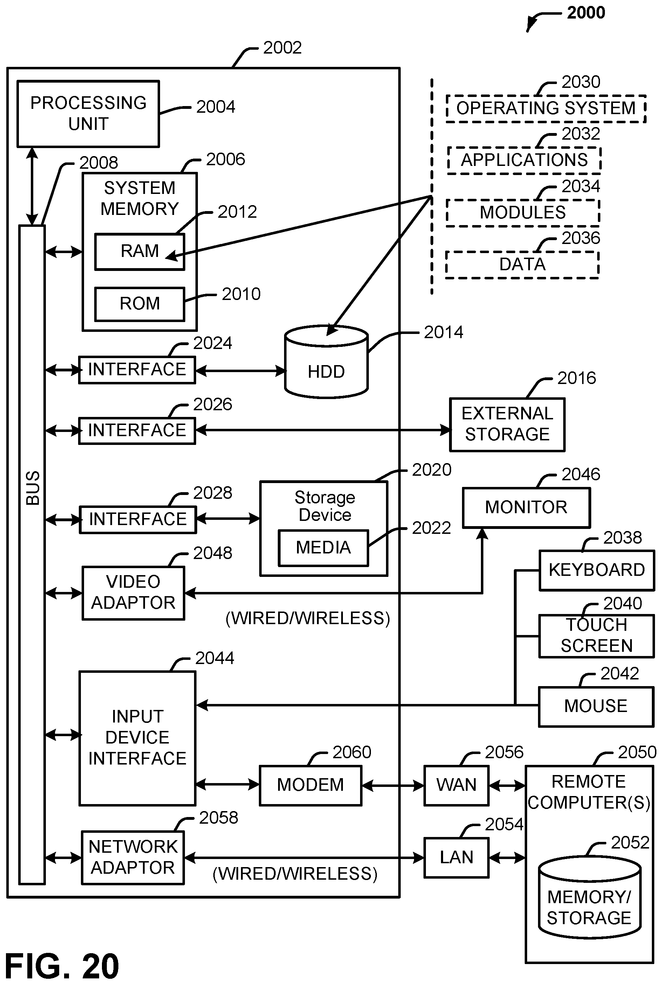

In one or more embodiments, a scientific instrument comprising and/or employing one or more embodiments described herein can be part of and/or employ a computing environment, such as the computing environment 2000 illustrated at FIG. 20. In one or more described embodiments, computer and/or computing-based elements can be used in connection with implementing one or more of the systems, devices, assemblies, components and/or methods shown and/or described in connection with FIGS. 1 and/or 5 to 14 and/or with other figures described herein.

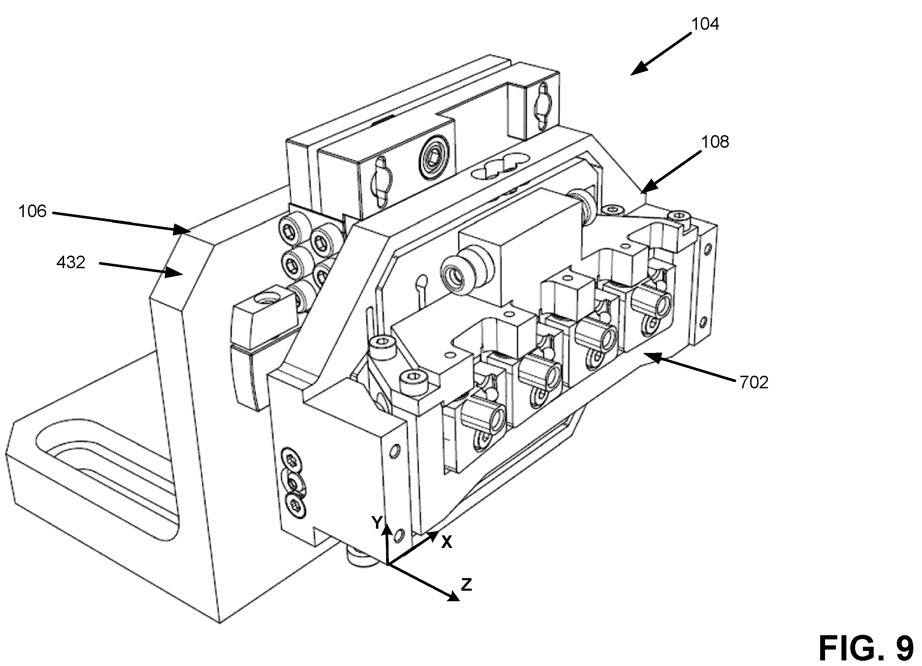

As illustrated at FIG. 1, the sample positioning system 104 can comprise a chamber door assembly 106 and a sample support assembly 108 that can be coupled to the chamber door assembly 106. It is noted that the chamber door assembly 106 will be discussed in detail below relative to FIGS. 4 to 7, a grid holder will be discussed in detail below relative to FIG. 8, and the sample support assembly 108 will be discussed below in detail relative to FIGS. 9 to 14.

Referring still to the non-limiting system 100 of FIG. 1, a scientific instrument 100 can provide analysis, such as imaging of, one or more samples 110. A sample 110, such as a lamella, can be positioned on a grid, which is also herein referred to as a lamella carrier 112. At least a pair of lamella carriers 112 can be fixedly or removably coupled to a grid holder 114, which is particularly illustrated at FIG. 8 and will be discussed in detail below. At least one grid holder 114, but up to four or more, such as ten, grid holders 114 can be retained at a sample positioning system 104, and specifically at respective receivers of the sample positioning system 104. For example, one receiver can receive one grid holder 114.

As shown, the grid holders 114 can be received into a load lock hold, such as where a loading station of the sample positioning system 104 (e.g., the grid holders 114 attached to a sample support cartridge) are received into a vacuum chamber 122 of the scientific instrument 102. It is noted that in one or more embodiments, the scientific instrument can comprise an optional load lock pre-chamber 120 (also herein referred to as a load lock or load lock chamber) into which the grid holders 114 can be first received before being moved and/or the vacuum chamber 122 can be a chamber that is not vacuum-sealed. In either case, the sample positioning system 104 can be sealed and/or closed against a chamber body 124 of the scientific instrument 102. A chamber body 124 can comprise a body of a vacuum chamber 122 and/or of a load lock pre-chamber 120.

Air in the vacuum chamber 122 (and/or load lock pre-chamber 120) can be exhausted. The vacuum chamber 122 can comprise a grid handling robot 128 or other automatic movement element that can remove the grid holders 114 and/or lamella carriers 112 from the sample positioning system 104, moving them to a wafer holder 130 within the vacuum chamber 122.

It is noted that, in one or more cases, one or more wafters can be loaded via a wafer load lock system 140 comprising an equipment front end module (EFEM) 142, wafer-load lock 144 and/or in-vacuum robot (IVR) 146 for loading the one or more wafters to the vacuum chamber 122, and particularly to the wafter holder 130.

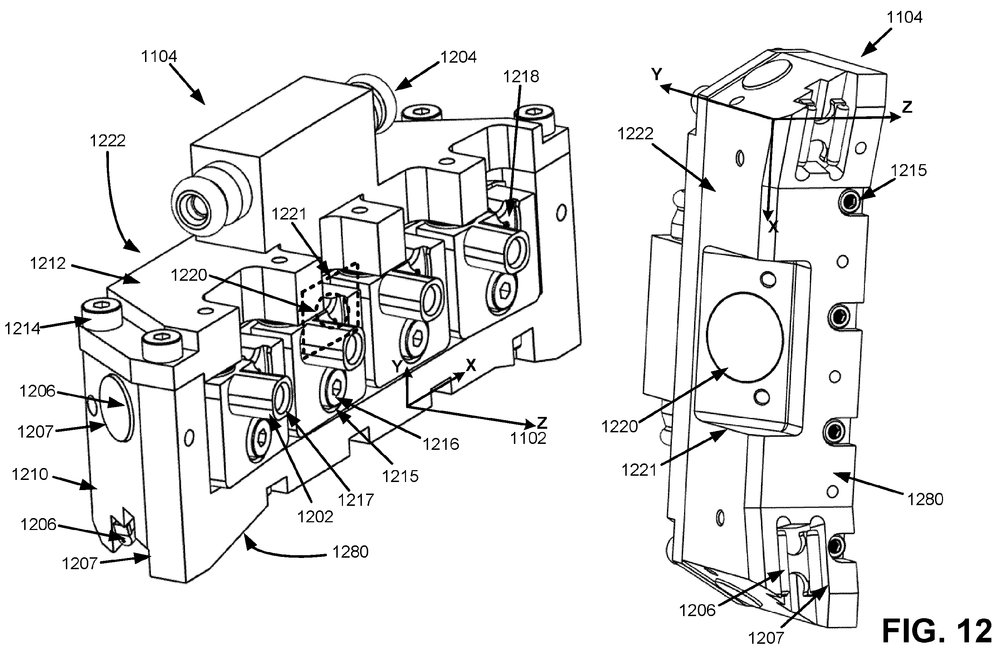

After analysis, evaluation, imaging, preparation and/or other process performed relative to the samples 110 within the vacuum chamber 122, the grid handling robot 128 can re-transfer the grid holders 114 and/or lamella carrier 112 from the wafer holder 130 to the sample positioning system 104. The vacuum chamber 122 and/or load lock chamber can be re-environmentalized, such as with air, and the sample positioning system 104 can be opened by disengaging (e.g., de-coupling) from the chamber body 124. The grid holders 114 can be removed from the sample positioning system 104 separately from a sample support cartridge and/or by removal and replacement (e.g., swapping) of the sample support cartridge of the sample positioning system 104, to be explained below (see, e.g., FIG. 12). In this way, rapid swapping and high sample throughput can be realized for the scientific instrument 102 using an embodiment of the sample positioning system 104 described herein.

Turning next to FIGS. 4 to 7, the scientific instrument 102 can comprise a load lock chamber 120 that can lead into, be coupled to, and/or be integral with the vacuum chamber 122. The scientific instrument 102 further can comprise a vacuum element 424 that can be employed to exhaust environment from the load lock chamber 120 and/or from the vacuum chamber 122. Or, in an alternative embodiment, separate vacuum elements 424 can be employed for the load lock chamber 120 and the vacuum chamber 122.

The sample positioning system 104, and particularly the chamber door assembly 106, will next be further described, including description regarding benefits of the sample positioning system 104 of rapid sample throughput, separated degrees of freedom for positional repeatability with the chamber body 124, and independent degrees of freedom for positional repeatability of the grid holders 114 relative to a coordinate system 126 of the scientific instrument 102 (e.g., such as a coordinate system 126 within the vacuum chamber, such as of the grid handling robot 128).

As illustrated, the sample positioning system 104 can comprise at least the chamber door assembly 106 for mating with, such as coupling to, a base unit, such as the chamber body 124 and/or a load lock body 424 of a load lock 120. In one or more cases, the load lock body 424 can be comprised by the chamber body 124.

The chamber door assembly 106 can comprise at least a retaining member, such as a door plate 432 and a retaining member holder, such as a door carriage 434. The door plate 432 can be couplable to the door carriage 434 for joint movement with the door carriage 434 into and out of engagement with the scientific instrument 102 or chamber body 124.

The door carriage 434 can comprise and/or be coupled to at least one, such as a pair, of rails 440 of a rail system 438. In one or more embodiments, the rail system 438 can be considered as part of the scientific instrument 102. The rail system 438 can couple the chamber door assembly 106, and thus also the instrument door system 104, to the scientific instrument 102. In one or more embodiments, the rail system 438 can couple to the base unit, such as the chamber body 124, and/or to the retaining member hold, such as the door carriage 434, such as by fasteners, a key and slot system, rail and slot system and/or any other suitable coupling interface allowing for at least movement of the door carriage 434 into and out of engagement with the chamber body 124. This movement can be along an axis that extends along a longitudinal extension of the rails 440, for example. Such axis can be parallel to and/or colinear with a depicted Z-direction of movement (442) of the chamber door assembly 106 relative to the scientific instrument.

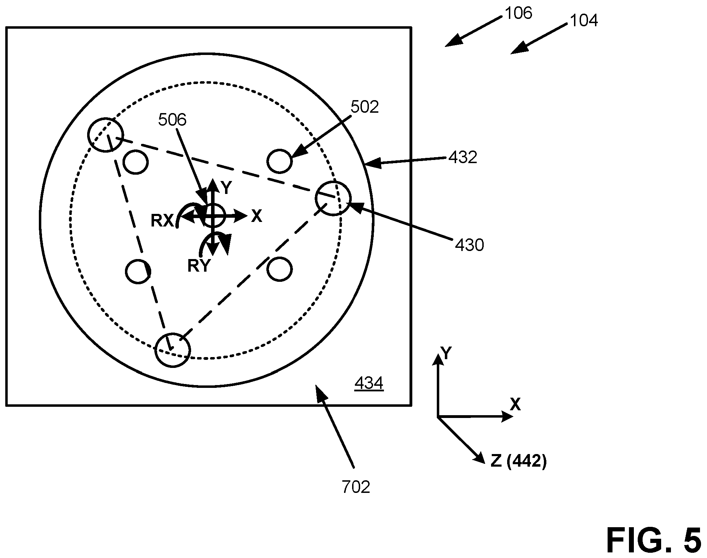

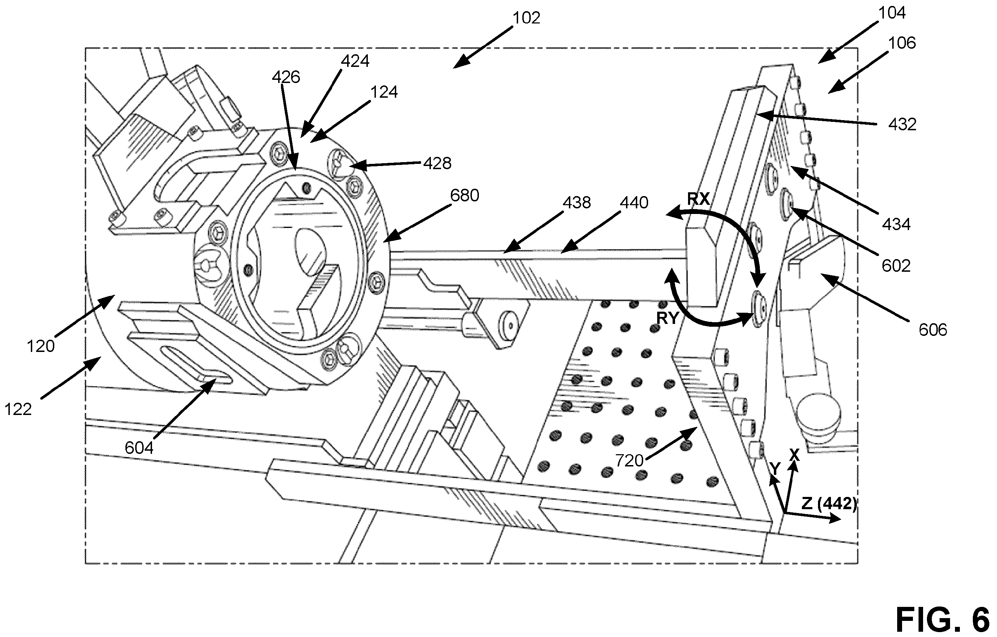

Illustrated at FIG. 4 is an elastic member symbol 436. This symbol 436 is provided merely to represent flexible compliance of an interface between the door carriage 434 and the door plate 432. As used herein, the term flexible compliance can comprise an elastic property of an element of the interface, a flexible property of an element of the interface, and/or an adjustability of at least one element relative to the other element. For example, as illustrated at FIG. 5, due to oversizing of fastener through holes 502 of the door plate 432, the door plate 432 can be coupled (e.g., by bolts and/or fasteners 602 illustrated at FIG. 6) to the door carriage 434. For example, fasteners 602 can be threaded into threaded bolt holes (not particularly shown) at the door carriage 434.

In one or more embodiments, the door plate 432 can additionally, and/or alternatively, be comprised of a flexible material allowing for elastic movement of the door plate 432 relative to the door carriage 434, such as when coupled to the door carriage 434. Such elastic movement can be in at least the three degrees of freedom noted above.

Accordingly, even while the door plate 432 is coupled to the door carriage 434, one or more degrees of freedom of the interface of the door plate 432 and door carriage 434 can be maintained. The one or more degrees of freedom can comprise at least three degrees of freedom. As illustrated at FIG. 5, this can comprise movement in an illustrated X-direction, movement in an illustrated Y-direction (that is orthogonal to the illustrated X-direction), and/or rotation about a X-direction, referred to as RX or rotation about the Y-direction, referred to as RY. In one or more cases, this can additionally, and/or alternatively, comprise movement about a Z-direction 442, referred to as RZ (not specifically shown at FIG. 5), where the Z-direction 442 is orthogonal to both the X-direction and the Y-direction. As noted above, the Z-direction 442 can be parallel to, and/or the same as, a direction of movement of the door carriage 434 along and/or provided by the rails 440.

Further regarding the chamber door assembly 106, one example, without being limited thereto, translation in each of the X-direction and Y-direction can be about 3 microns (µm) in each of positive and negative directions for each of the X-direction and the Y-direction. Additionally, and/or alternatively, rotation in RX and/or RY can be about +/- 2 degrees, or about +/- 1 degree, for example, without being limited thereto.

As illustrated at FIG. 6, the one or more degrees of freedom provided by the interface of the door plate 432 and door carriage 434 further can comprise rotation about the X-direction of FIG. 5, referred to as RX, and/or rotation about the Y-direction of FIG. 5, referred to as RY. Rotation in each of the RX and RY can be about +/- 2 degrees, or about +/- 1 degree, for example, without being limited thereto.

It is noted that each of these five different degrees of freedom can be maintained after movement along the Z-direction to put the chamber door assembly 106 into a state coupled to the chamber body 124 by a kinematic coupling. For example, the chamber body 124 (e.g., a body 424 of the load lock 120) and the door plate 432 each can comprise a portion of the kinematic coupling. For example, the door plate 432 can comprise one or more first kinematic coupling elements 430, and the body 424 of the load lock 120 can comprise one or more corresponding second kinematic coupling elements 428.

As used herein, a kinematic coupling is a coupling that provides for limited adjustability between elements of the kinematic coupling. For example, kinematic coupling elements can fit together (e.g., couple) without being fixed to one another. For example, in the case of the embodiment of FIGS. 4 and 5, the first kinematic coupling elements 430 and the second kinematic elements 432 can be arranged to at least provide for a degree of freedom of rotation about the Z-direction 442.

In one or more embodiments, the first kinematic coupling elements 430 or the second kinematic coupling elements 428 can comprise concave blocks, vee blocks or other suitably shaped elements to receive the other of the first kinematic coupling elements 430 and the second kinematic elements 428. Thus, the other of the first kinematic coupling elements 430 and the second kinematic elements 428 can comprise convex blocks, dome-shaped blocks, spherical blocks, convex V-shapes, and/or other suitable elements for providing the corresponding kinematic coupling. As illustrated, the first kinematic coupling elements 430 (e.g., at the door plate 432) comprise concave vee blocks and the second kinematic coupling elements 428 (e.g., at the vacuum chamber body 124) comprise corresponding convex V-shapes for receiving the concave vee blocks.

As illustrated at the example figures, the first kinematic coupling elements 430 are arranged at a vacuum-chamber-facing side of the door plate 432 (e.g., a chamber-side 702). As illustrated at FIG. 5, the first kinematic coupling elements 430 can be arranged in a circular pattern and/or a triangular pattern to allow for the rotational adjustment about the Z-axis/Z-direction 442 (FIG. 4).

The second kinematic coupling elements 428 are arranged at an air-side-facing side 680 (FIG. 6) of the body 424. As noted above, it is appreciated that in one or more embodiments, the vacuum load lock 120 (and thus also the body 424) can be omitted, and thus the second kinematic coupling elements instead can be arranged at an air-side-facing side of the body 122. In one or more additional and/or alternative embodiments, the body 424 can be considered as part of, such as an extension of, the body 122.

Once alignment of the door plate 432 is achieved relative to the door carriage 434, alignment of the kinematic coupling elements 428 and 430 can be suitably achieved in the various degrees of freedom discussed above. This can allow for easy movement of the door plate 432 against the elastic member 426 while allowing for concurrent alignment of the samples carried by the chamber door assembly 106, such as relative to the base unit (e.g., chamber body 124). That is, based on the use of the kinematic coupling elements 428 and 430, and based on the flexible compliance of the interface between the door plate 432 and the door carriage 434, the chamber door assembly 106 can address a generation of friction produced by engagement of the door plate 432 with the elastic element 426.

The elastic element 426 can be any suitable elastic element and/or comprise any suitable elastic material for facilitating a seal, such as a vacuum seal, between the vacuum load lock body 424 and the chamber door assembly 106 (e.g., the door plate 432). In one or more embodiments, the elastic element 426 can be an o-ring, such as an elastomer or fluoroelastomer o-ring. While the elastic element 426 is illustrated as being disposed at a recess of the vacuum load lock body 424, in one or more other embodiments, an elastic element 426 can alternatively, and/or additionally, be disposed at a chamber-facing side 702 of the door plate 432.

The previously-noted, fastener-based coupling can be tightened (e.g., fasteners 602 illustrated at FIG. 6 can be tightened), thus providing more rigid, such as fixed, coupling between the door plate 432 and door carriage 434.

Fixed engagement of the door plate 432 with the elastic member 426 can provide for a seal of the vacuum load lock 120 and/or vacuum chamber 122. In one or more embodiments, the scientific device can comprise a vacuum seal sensor 431, coupled to a processor 406, such as for determining an adequate seal of the load lock chamber 122 and/or vacuum chamber 122.

Further, in one or more embodiments, the vacuum chamber body 124 and/or load lock chamber body 424 can comprise a retaining element 604 for being engaged by a suitable retaining element 606 of the chamber door assembly 106. The interface provided can be latch-based, for example, such as to provide fixed coupling between the chamber door assembly 106 and the vacuum chamber body 124.

As a brief summary of the chamber door assembly 106, prior to fixed and/or more rigid coupling of the door plate 432 and the door carriage 434 to one another, coupling between the door plate 432 and the door carriage 434 can be provided. This coupling, differently, can be adjustable, to allow for maintaining some level of adjustability between the door plate 432 and the load lock chamber body 424, in addition to maintaining some level of adjustability between the door plate 432 and the door carriage 434. Accordingly, shimming (as utilized in existing frameworks) of parts relative to one another (such as of a door relative to a door holder) can be reduced and/or altogether eliminated, thereby rapidly increasing a preparation time for use of the scientific instrument 102 as compared to a preparation time provided by existing frameworks.

Turning next to FIG. 8, illustrated is an orthogonal view of an example grid holder 114 that can be retained by the sample positioning system 104 and/or by the wafer holder 130. As depicted, the grid holder 144 can comprise at least a pair of lamella carriers (112) or grids that can support (e.g., hold) at least a sample 110 each. In one or more cases, the lamella carriers 112 can be removed for processing, preparation, decontamination, replacement, etc., without being limited thereto.

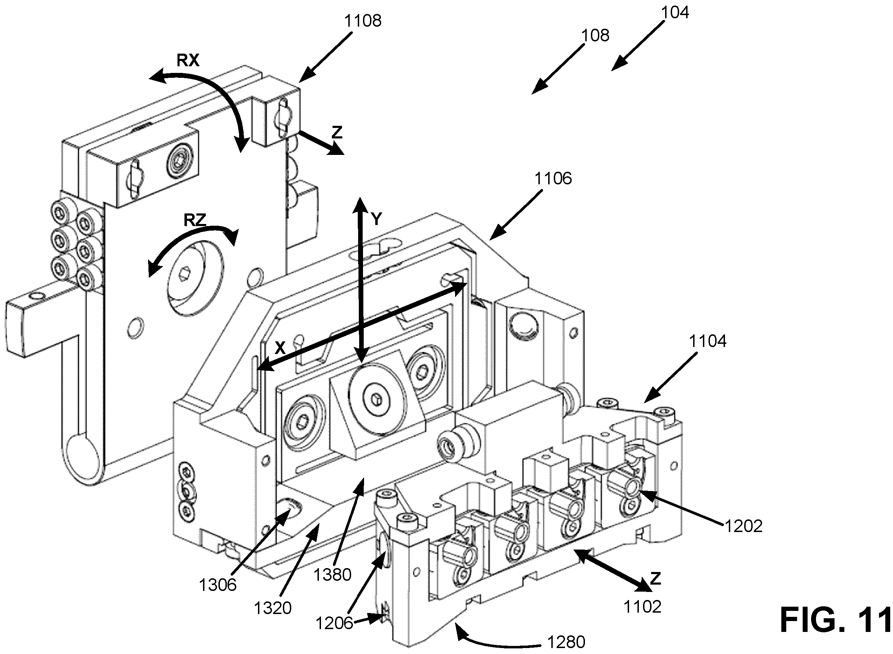

The grid holder 114 can comprise a mating element 802 that can mate with a receiver 1202 (FIGS. 11 and 12) of the sample positioning system 104. More particularly, the receiver 1202 can be an integral and/or removable aspect of the sample support cartridge 1104 (FIG. 11) of the sample support assembly 108. The illustrated mating element 802 can be a key, such as a post (e.g., cylindrical post), while an aligner 804 can be spaced apart from the mating element 802 to provide for two-point alignment of the grid holder 114 relative to receiver 1202 of a sample support cartridge 1104. In one or more embodiments, the aligner 804 can be and/or comprise a nylon material or other like material. The mating element 802, such as a post, can be received into a receiving slot 1217 of the receiver 1202, while the aligner 804 can be received at a corresponding notch 1218 of the sample support cartridge 1104.

In one or more other embodiments, shapes of the receiving slot 1217 and mating element 802 and/or shapes of the notch 1218 and aligner 804 can be reversed and/or differently-shaped mating elements 1217, 1218, 802 and/or 804 can be employed.

Turning now briefly back to FIG. 7, and also looking to FIG. 9, a chamber-side 702 (e.g., a vacuum-side) of the sample positioning system 104 is illustrated. As depicted, the sample support assembly 108 can be coupled to the chamber door assembly 106 for joint movement with the chamber door assembly 106.

The sample support assembly 108 can comprise a compact assembly comprising a sample support cartridge 1104, position adjuster 1106 and flex adjuster 1108. Accordingly, it will be appreciated that the chamber door assembly 106, and thus the use of the kinematic coupling elements 428 and 430, and the use of the flexible compliance of the interface between the door plate 432 and the door carriage 434 (and/or of the door plate 432 and/or door carriage 434), can also provide for positional repeatability and/or locating of the grids holders 114 and/or sample support cartridge 104 relative to the vacuum chamber 122/load lock chamber 120. That is, adjustment and/or alignment of one or more elements of the chamber door assembly 106 can thus allow for adjustment and/or alignment of the sample support cartridge 1104, separate from any other adjustment and/or alignment of one or more elements of the sample support assembly 108.

In one or more embodiments, the positional repeatability of the grids holders 114 and/or sample support cartridge 104 can be provided at a low micron level (e.g., about 1 micron, or about 2 micron, or about 3*σ* = 0.7*µm*) by the chamber door assembly 106, the sample support assembly 108, and/or a combination thereof.

Turning next to FIGS. 9 to 12, and still referring to FIG. 7, the sample positioning system 104, and particularly the sample support assembly 108, will now be further described. This will include description regarding benefits of the sample positioning system 104 of rapid sample throughput, repeatable and accurate sample alignment, separated degrees of freedom for positional repeatability with the chamber body 124, and separated degrees of freedom for positional repeatability of the grid holders 114 relative to a coordinate system 126 of the scientific instrument 102 (e.g., such as a coordinate system 126 within the vacuum chamber, such as of the grid handling robot 128).

Referring first in particular to FIG. 11, an exploded view of the sample support assembly 108 is illustrated. As shown, the sample support cartridge 1104 is configured to be received by a retainer, such as the position adjuster 1106. Indeed, as mentioned above, a sample support cartridge 1104 can be easily removed from the position adjuster 1106, such as due to a magnetic coupling and/or kinematic coupling therebetween, to allow for swapping out/swapping in of other sample support cartridges 1104. This can allow for rapid increase in sample throughput to the vacuum side of the associated scientific instrument 102, as compared to existing frameworks.

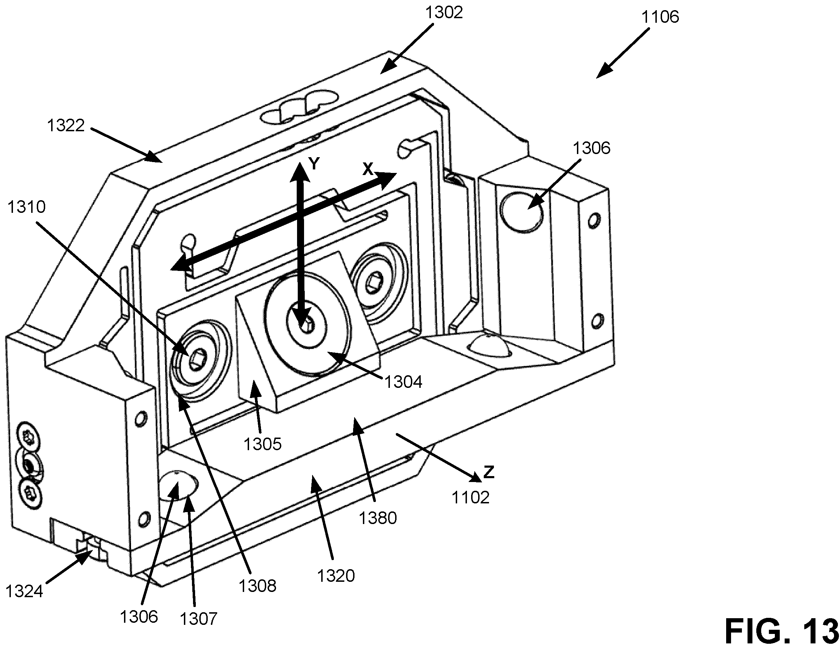

As illustrated at FIG. 11, the sample support cartridge 1104 can be moved generally along an illustrated Z-direction for engagement with and disengagement from the position adjuster 1105. When the sample support assembly 108 is coupled to the chamber door assembly 106, the Z-direction 1102 of FIG. 11 can be parallel to and/or colinear with the Z-direction 424 of FIG. 4. As shown at FIGS. 12 and 13, the sample support cartridge 1104 and the position adjuster 1106 can be kinematically coupled allowing for easy alignment of the sample support cartridge 1104 with the position adjuster 1106, which also can be referred to as a retaining member.

Turning next to FIG. 12 and first to the sample support cartridge 1104, this element can have an integral construction and/or can be comprised of a set of elements coupled to one another. In one or more embodiments, such as illustrated at FIG. 12, the sample support cartridge 1104 can comprise a base component 1210 that is coupled to a top component 1212, such as by a set of one or more fasteners 1214, such as bolts. A retaining post 1204 can extend from the top component 1212 to allow for gripping of the sample support cartridge 1104 by an air-side robotic gripping system and/or automatic gripping system (not shown). A set of one or more receivers 1202 can be coupled between the top component 1212 and the base component 1210, such as to the base component 1210, such as by a set of one or more fasteners 1216, such as bolts. For example, at least one fastener 1216 can be employed per receiver 1202.

Use of individual receivers 1202, and use of oversized fastener holes 1215 therewith, can allow for adjustment of about 1 micron or about 2 micron of the individual receivers 1202 separately from one another and relative to the base component 1210.

In one or more other embodiments, a set of two or more receivers 1202 can be integral with one another.

As illustrated, a receiver 1202 can comprise a recess 1217, such as a key or slot, for receiving the mating element 802 of a grid holder 114. Likewise, a receiver can comprise a notch 1218 for receiving an aligner 804 of a same grid holder 114.

Discussion turns next to the kinematic coupling at the sample support assembly 108. Similar to the kinematic coupling of the chamber door assembly 106, at the kinematic coupling of the sample support assembly 108, each of the sample support cartridge 1104 and the position adjuster 1106 can comprise a portion of a kinematic coupling. For example, the sample cartridge 1104 can comprise one or more first kinematic coupling elements 1206, and the position adjuster 1106 can comprise one or more corresponding second kinematic coupling elements 1306. In one or more embodiments, the first kinematic coupling elements 1206 or the second kinematic coupling elements 1306 can comprise concave blocks, vee blocks or other suitably shaped elements to receive the other of the first kinematic coupling elements 1206 and the second kinematic elements 1306. Thus, the other of the first kinematic coupling elements 1206 and the second kinematic elements 1306 can comprise convex blocks, dome-shaped blocks, spherical blocks, convex V-shapes, and/or other suitable elements for providing the corresponding kinematic coupling.

For example, in the case of the embodiment illustrated at FIGS. 9 to 13, the first kinematic coupling elements 1206 and the second kinematic elements 1306 can be arranged to at least provide for two degrees of freedom along respective X and Y directions as illustrated at FIGS. 11 and 12. When the sample support assembly 108 is coupled to the chamber door assembly 106, these X and Y directions can be parallel to and/or colinear with the X and Y directions of the chamber door assembly 106 (e.g., as illustrated at FIG. 5).

Looking to the sample support cartridge 1104, the first kinematic coupling elements 1206 can be arranged transverse to one another, such as within corresponding recesses 1207, at surfaces that are likewise transverse to one another (e.g., orthogonal to one another). Looking to the position adjuster 1106, the second kinematic coupling elements 1306 also can be arranged transverse to one another, such as within corresponding recesses 1307, at surfaces that are transverse to one another (e.g., orthogonal to one another). In this way, the kinematic arrangement between the sample support cartridge 1104 and the position adjuster 1106 can allow for adjustment/alignment of the sample support cartridge 1104 relative to the position adjuster 1106, when the kinematic coupling elements 1206 and 1306 are coupled with (e.g., engaged with) one another.

In one or more embodiments, this adjustment/alignment can be in the illustrated X and Y directions. For example, this alignment can be about 1.2 mm in each of positive and negative directions along each of the X and Y directions, without being limited thereto.

While this adjustment/alignment can be minimal, it can allow for slight adjustment of the sample support cartridge 1104 relative to the grid handling robot 128 when the sample positioning system 104 is engaged/closed at the vacuum chamber body 124 of the scientific instrument 102, resulting in the sample support cartridge 1104 being within the vacuum side of the scientific instrument 1104 (e.g., within the chamber 122 and/or 120).

Notably, the transverse positioning of the kinematic coupling elements 1206 and 1306 also can provide for restriction of movement of the sample support cartridge 1104. This restriction of movement can be in at least four degrees of freedom, or in at least all six degrees of freedom, to provide for support of the sample support cartridge 1104 relative to the position adjuster 1106, such as in response to engagement of the grid handling robot 128 with one or more grid holders 114 that are coupled at the receivers 1202 (FIG. 12) of the sample support cartridge 1104.

Looking at FIG. 11, in one or more embodiments, the second kinematic coupling elements 1306 can be positioned a second distance from second mating surface 1380 that is the same as a first distance between the first coupling elements 1206 and the corresponding first mating surface 1280. In this way, as the support cartridge 1104 is inserted into the position adjuster 1106, engagement of the second kinematic coupling elements 1306 with the corresponding first kinematic coupling elements 1206 can limit and/or prevent tilting of the support cartridge 1104 relative to the position adjuster 1106. That is, the engagement of the first and second kinematic coupling elements 1206, 1306 can provide resistance to rotation of the support cartridge 1104 relative to the position adjuster 1106.

As mentioned above, the sample support cartridge 1104 and the position adjuster 1106 can be magnetically-coupled to one another. For example, the position adjuster 1106 can comprise a first magnetic element 1304 and the sample support cartridge 1104 can comprise a second magnetic element 1220 at a backside 1222 (e.g., a side to be facing the position adjuster 1106) of the sample support cartridge 1104. In one or more embodiments, the first magnetic element 1304 or the second magnetic element 1220 can be disposed in a raised key 1305, while the other of the first magnetic element 1304 and the second magnetic element 1220 can be disposed in a corresponding slot 1221. In one or more embodiments, one of the slot 1221 or key 1305 can be larger than the other of the slot 1221 and key 1305, to allow for spacing therebetween when coupled. This spacing therebetween can allow for easy engagement of the corresponding key/slot interface and adjustment of the key/slot interface, while also allowing for the slight adjustability provided by the kinematic coupling elements 1206 and 1306 with one another.

Turning now FIG. 13 and to further description of the position adjuster 1106, this component can have an integral construction and/or can be comprised of a set of elements coupled to one another. In one or more embodiments, as illustrated at FIG. 13, the position adjuster 1106 can comprise a base component 1320 and a main body component 1322 that can be coupled to one another such as be fasteners 1324, such as bolts.

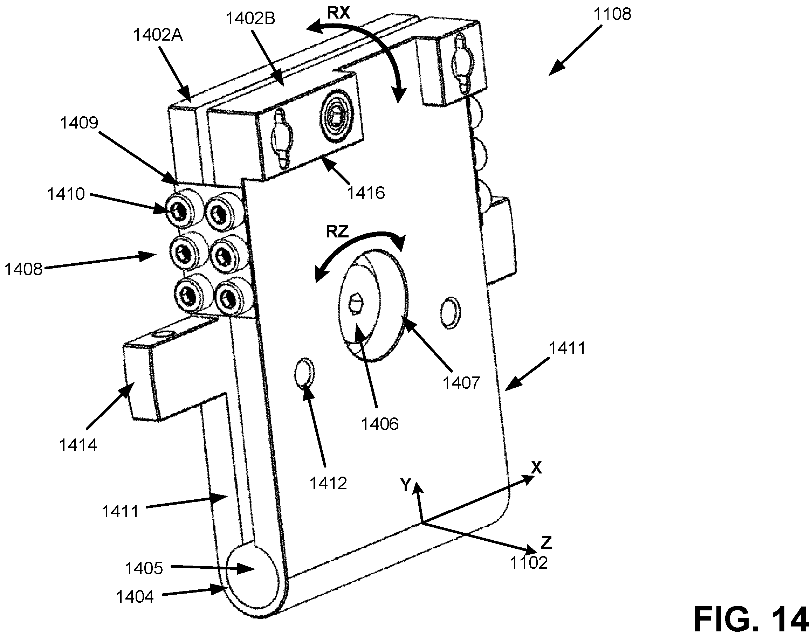

To allow for coupling of the position adjuster 1106 to the flex adjuster 1108, the position adjuster 1106 can comprise one or more through holes 1308, such as at least a pair of through holes 1308. Correspondingly, the flex adjuster 1108 can comprise at least a pair of corresponding fastener holes 1412 (FIG. 14), such as threaded holes. The through holes 1308 can be oversized relative to corresponding fasteners 1310, such as bolts, to allow for adjustment/alignment of the position adjuster 1106, relative to the flex adjuster 1108, when coupled to the flex adjuster 1108. Such adjustment/alignment can be along the X-direction and/or Y-direction illustrated at FIGS. 11 and 13, which are orthogonal to one another, and/or within a plane comprising axes represented by the X-direction and Y-direction of FIGS. 11 and 13.

Turning now to FIG. 14 and to further description of the flex adjuster 1108, this component also can have an integral construction and/or can be comprised of a set of elements coupled to one another. In one or more embodiments, as illustrated at FIG. 14, the flex adjuster 1108 can comprise a first face element 1402A, such as a face plate, and a second face element 1402B, such as another face plate.

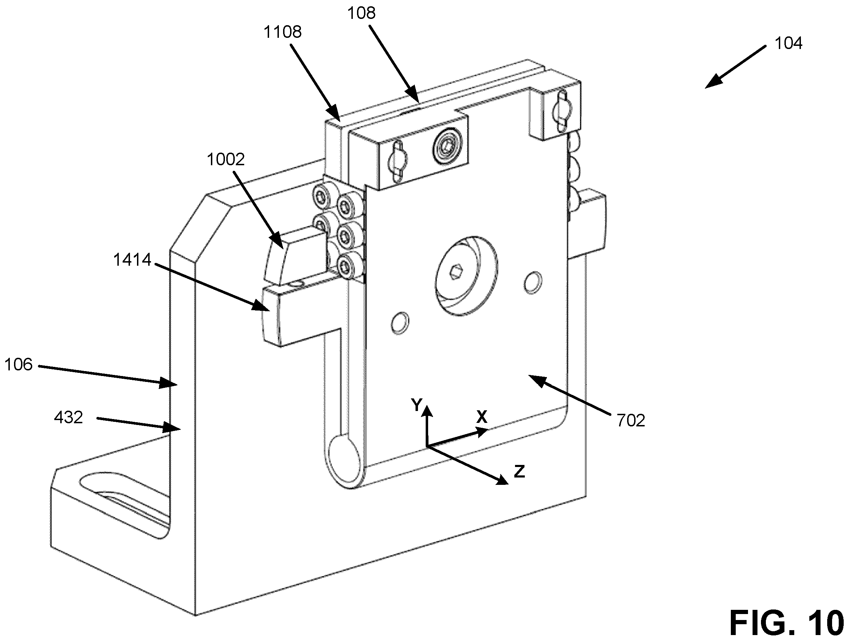

As illustrated at FIG. 11, the second face plate 1402B can be arranged to face the position adjuster 1106 and can comprise the fastener holes 1412. As illustrated at FIG. 10, the first face plate 1402A can be arranged to face the door plate 432 of the chamber door assembly 106.

Looking again to FIG. 14, the face plates 1402A and 1402B can be arranged to be generally parallel with one another but to allow for control of a distance between (e.g., spacing between) the face plates 1402A and 1402B. That is, the first face plate 1402A can be arranged to be spaced from and/or to abut the second face plate 1402B. This can be facilitated by the connecting portion 1404 that extends between bottom portions of each of the first face plate 1402A and second face plate 1402B. A cavity 1405 can extend within the connecting portion 1404, such as between opposite distal sides 1411 of the flex adjuster 1108. The connecting portion 1404 thus connects the first face plate 1402A and second face plate 1402B such that the first face plate 1402A, second face plate 1402B and connecting portion 1404 are integral with one another. That is, via the connecting portion 1404, which can flex and have a thinner thickness than first face plate 1402A and second face plate 1402B, the first face plate 1402A and second face plate 1402B can be adjusted/aligned relative to one another. Put another way, the cavity 1405 and/or thinner thickness of the connecting portion 1414 relative to the face plates 1402A/1402B can allow for the limited adjustability in the RX degree of freedom as illustrated at FIG. 14 (rotation about the X-direction of FIG. 14) of the face plates 1402A/1402B relative to one another. In one example, both positive and negative RX adjustment can be about 2 degrees, without being limited thereto.

It will be appreciated that the first and second face element 1402A and/or 1402B can have alternative construction and/or shape, such as non-planer plates, in one or more other embodiments.

The above-noted adjustment/alignment can be facilitated by a first adjustment element 1406 and/or a second adjustment element 1408.

The first adjustment element 1406 can comprise a fastener, such as a bolt, which can fasten through a set of through holes 1407 of the first and second face elements 1402A and 1402B into a fastener hole, such as a threaded hole 506 (FIG. 5), at the door plate 432. In one or more cases, the first adjustment element 1406 can further comprise a spring element. This spring element, such as a Belleville spring, can allow for high force engagement in combination with allowing rotation about the Z-direction 442 (e.g., RZ).

In one or more cases, the set of through holes 1407 can be non-oversized to limit degrees of freedom provided by the flex adjuster 1108 relative to adjustment/alignment of the whole of the sample support assembly 108. In one or more cases, a washer or other element can be employed between the first and second face elements 1402A and 1402B.

Rotation about a respective Z-direction 1102 of the flex adjuster 1108 (e.g., RZ), and thus also of the sample support assembly 108 relative to the chamber door assembly 106, can be allowed via non-fixed coupling of the first adjustment element 1406 to the door plate 432. In one or more examples, positive and/or negative RZ adjustment can be about 2 degrees, or about 1 degree, without being limited thereto. Tightening of the first adjustment element 1406 relative to the door plate 432 can restrict this rotation, such as in view of the spring element of the first adjustment element.

Additionally, and/or alternatively, in one or more embodiments, one of the through holes 1407 of the set of through holes 1407 can be a threaded hole while the other through hole 1407 of the set of through holes 1407 can be non-threaded. For example, the hole 1407 of the first face element 1402A can be threaded. This can allow for causing spacing between the first and second face elements 1402A and 1402B by rotating of the fastener 1406 (e.g., first adjustment element 1406).

The second adjustment element 1408 can comprise a supporting element 1409, such as a plate, which can be shaped to mate with one of the opposite distal sides 1411 of the first and second face elements 1402A and 1402B. As illustrated, a pair of supporting elements 1409 can be employed, extending from the distal sides 1411 of the first face element 1402A. In one or more cases, a thickness (e.g., in the Z-direction 1102) of a supporting element can be the same as, or less than, a thickness of the first face element 1402A also in the Z-direction 1102. This non-influencing locking mechanism does not affect an adjusted position when fasteners 1410 and/or the first adjustment element 1406 are tightened, but can have a minimal amount of flexibility, due to the thinness thereof in the Z-direction 1102, relative to rotation in the X-direction (e.g., RX).

A set of fasteners 1410, such as bolts, can extend through holes in the supporting elements 1409 and into fastening holes at the distal sides 1411 of the first and second face elements 1402A and 1402B, such as threaded holes. In one or more cases the holes of the supporting element 1409 can be oversized relative to the fasteners 1410 and/or can instead be shaped as slots, ellipses, etc. This can allow for adjustment alignment of the first and second face elements 1402A and 1402B relative to one another, but still allow for fitting of the fasteners 1410 within the respective holes at the distal sides 1411. Tightening of the fasteners 1410 against the supporting elements 1409 relative to the distal sides 1411 can limit and/or fix alignment between the pair of face elements 1402A and 1402B.

In summary, rotation about a respective X-direction at FIG. 14 (RX) of the flex adjuster 1108, and thus also of the sample support assembly 108 relative to the chamber door assembly 106, can be allowed via non-fixed coupling of the second adjustment element 1408 relative to the door plate 432. Tightening of the second adjustment element 1408 relative to the pair of first and second face elements 1402A and 1402B, and relative to the door plate 432, can restrict this rotation.

As additionally illustrated at FIGS. 10 and 14, the first face element 1402A can comprise one or more support extensions 1414, for use in bracing the flex adjuster 1108 against the door plate 432, and/or for limiting RX movement of the flex adjuster 1108 relative to the door plate 432.

As additionally illustrated at FIGS. 7 and 14, the second face element 1402B can comprise an upper support 1416 extending outwardly (e.g., in the z-direction 1102) from a main body portion of the second face element 1402B. The upper body 1322 of the position adjuster 1106, such as an upper surface 1302 of the position adjuster 1106 (FIG. 13), can be received into (e.g., can abut) the upper support 1416. Additionally, and/or alternatively, the upper support 1416 can limit upward adjustment of the position adjuster 1106 along the Y-direction at FIGS. 13 and 14.

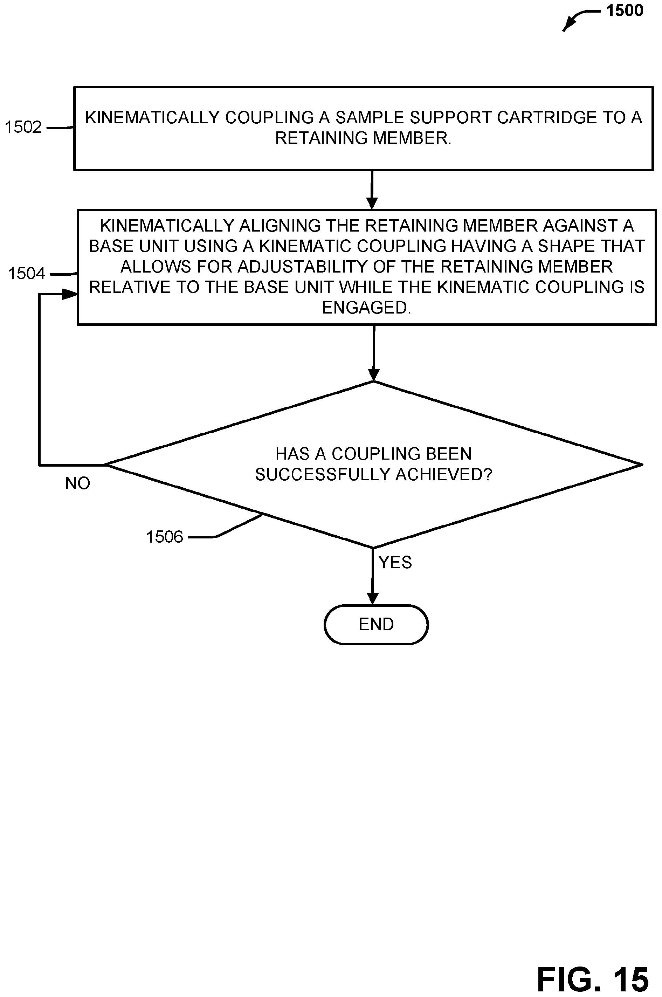

As a summary of the above-described components and/or functions thereof, referring next to FIG. 15, illustrated is a flow diagram of an example, non-limiting method 1500 that can facilitate a process for positional repeatability of sample support cartridge relative to a scientific instrument 102, in accordance with one or more embodiments described herein, such as the non-limiting system 100 of FIG. 1. While the non-limiting method 1500 is described relative to the non-limiting system 100 of FIG. 1, the non-limiting method 1500 can be applicable also to other systems and/or assemblies described herein, such as the instrument door assembly 106 and/or sample support assembly 108. Repetitive description of like elements and/or processes employed in respective embodiments is omitted for sake of brevity.

At 1502, the non-limiting method 1500 can comprise kinematically coupling a sample support cartridge to a retaining member.

For example, the sample support cartridge 1104 can be kinematically coupled to a retaining member (e.g., door plate 432 via the sample support assembly 108). See, e.g., FIG. 9.

For another example, the sample support cartridge 1104 can be kinematically coupled to a retaining member (e.g., position adjuster 1106). See, e.g., FIG. 9.

At 1504, the non-limiting method 1500 can comprise kinematically aligning the retaining member against a base unit using a kinematic coupling having a shape that allows for adjustability of the retaining member relative to the base unit while the kinematic coupling is engaged.

For example, the retaining member (e.g., door plate 432) can be kinematically aligned against a base unit (e.g., vacuum chamber body 124 and/or load lock chamber body 424) for adjustability of the retaining member (e.g., door plate 432) relative to the base unit (e.g., vacuum chamber body 124 and/or load lock chamber body 424) while the kinematic coupling (e.g., the first kinematic coupling elements 430 and the second kinematic elements 428) is engaged. See, e.g., FIG. 4.

For another example, the retaining member (e.g., position adjuster 1106) can be kinematically aligned against a base unit (e.g., vacuum chamber body 124 and/or load lock chamber body 424 via the flex adjuster 1108) for adjustability of the retaining member (e.g., position adjuster 1106) relative to the base unit (e.g., vacuum chamber body 124 and/or load lock chamber body 424 via the flex adjuster 1108) while the kinematic coupling (e.g., the first kinematic coupling elements 1206 and the second kinematic elements 1306) is engaged. See, e.g., FIG. 11.

At 1506, the non-limiting method 1500 can comprise determining, such as by a sensor associated with a processor of the scientific instrument (e.g., scientific instrument 102) whether a coupling has been successfully achieved. If yes, the non-limiting method 1500 can proceed to be ended. If not, step 1504 can be repeated.

For example, vacuum seal can be determined, such as by a vacuum seal sensor (e.g., vacuum seal sensor 431) coupled to a processor (e.g., processor 406) of the scientific instrument (e.g., scientific instrument 102). See, e.g., FIG. 4.

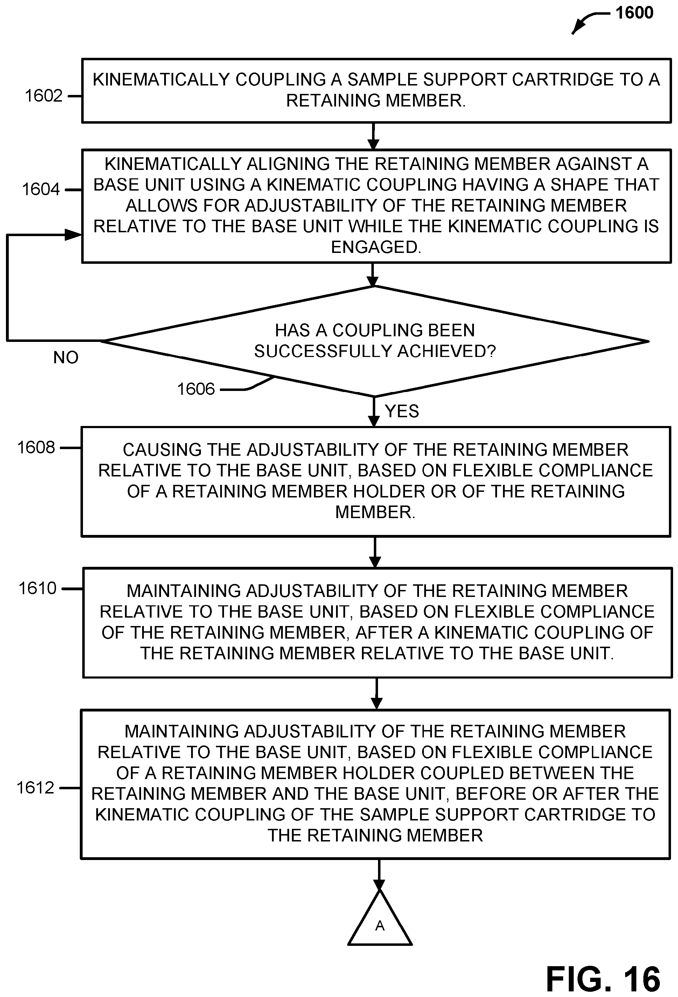

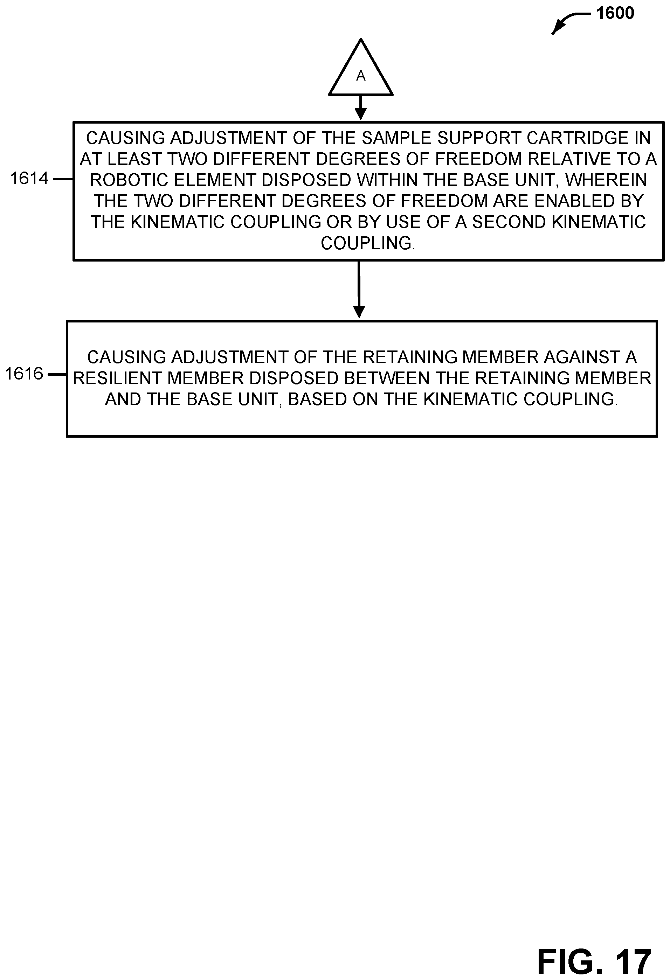

As another summary of the above-described components and/or functions thereof, referring next to FIGS. 16 and 17, illustrated is a flow diagram of an example, non-limiting method 1600 that can facilitate a process for positional repeatability of sample support cartridge relative to a scientific instrument 102, in accordance with one or more embodiments described herein, such as the non-limiting system 100 of FIG. 1. While the non-limiting method 1600 is described relative to the non-limiting system 100 of FIG. 1, the non-limiting method 1600 can be applicable also to other systems and/or assemblies described herein, such as the instrument door assembly 106 and/or sample support assembly 108. Repetitive description of like elements and/or processes employed in respective embodiments is omitted for sake of brevity.

At 1602, the non-limiting method 1600 can comprise kinematically coupling a sample support cartridge to a retaining member.

For example, the sample support cartridge 1104 can be kinematically coupled to a retaining member (e.g., door plate 432 via the sample support assembly 108). See, e.g., FIG. 9.

For another example, the sample support cartridge 1104 can be kinematically coupled to a retaining member (e.g., position adjuster 1106). See, e.g., FIG. 9.

At 1604, the non-limiting method 1600 can comprise kinematically aligning the retaining member against a base unit using a kinematic coupling having a shape that allows for adjustability of the retaining member relative to the base unit while the kinematic coupling is engaged.

For example, the retaining member (e.g., door plate 432) can be kinematically aligned against a base unit (e.g., vacuum chamber body 124 and/or load lock chamber body 424) for adjustability of the retaining member (e.g., door plate 432) relative to the base unit (e.g., vacuum chamber body 124 and/or load lock chamber body 424) while the kinematic coupling (e.g., the first kinematic coupling elements 430 and the second kinematic elements 428) is engaged. See, e.g., FIG. 4.

For another example, the retaining member (e.g., position adjuster 1106) can be kinematically aligned against a base unit (e.g., vacuum chamber body 124 and/or load lock chamber body 424 via the flex adjuster 1108) for adjustability of the retaining member (e.g., position adjuster 1106) relative to the base unit (e.g., vacuum chamber body 124 and/or load lock chamber body 424 via the flex adjuster 1108) while the kinematic coupling (e.g., the first kinematic coupling elements 1206 and the second kinematic elements 1306) is engaged. See, e.g., FIG. 11.

At 1606, the non-limiting method 1600 can comprise determining, such as by a sensor associated with a processor of the scientific instrument (e.g., scientific instrument 102) whether a coupling has been successfully achieved. If yes, the non-limiting method 1600 can be proceeding to step 1608. If not, step 1604 can be repeated.

For example, vacuum seal can be determined, such as by a vacuum seal sensor (e.g., vacuum seal sensor 431) coupled to a processor (e.g., processor 406) of the scientific instrument (e.g., scientific instrument 102). See, e.g., FIG. 4.

At 1608, the non-limiting method 1600 can comprise causing the adjustability of the retaining member relative to the base unit, based on flexible compliance of a retaining member holder or of the retaining member.

For example, an interface between the retaining member holder (e.g., door carriage 434) and the retaining member (e.g., door plate 432), such as via the oversizing of fastener through holes 502 of the door plate 432, can allow for compliance of the retaining member (e.g., door plate 432) relative to the base unit (e.g., vacuum chamber body 124 and/or load lock chamber body 424).

At 1610, the non-limiting method 1600 can comprise maintaining adjustability of the retaining member relative to the base unit, based on flexible compliance of the retaining member, after a kinematic coupling of the retaining member relative to the base unit.

For example, after kinematic coupling of the retaining member (e.g., door plate 432) to the base unit (e.g., vacuum chamber body 124 and/or load lock chamber body 424), adjustability of the retaining member (e.g., door plate 432) can be maintained, relative to the base unit (e.g., vacuum chamber body 124 and/or load lock chamber body 424) based on use of the kinematic coupling (e.g., the first kinematic coupling elements 430 and the second kinematic elements 428). Flexible compliance, as discussed above, can be due to the kinematic coupling and/or due to a flexible material, such as an elastic material, being employed for the door plate 432. It is noted that this adjustability can be maintained prior to any fixed coupling of the chamber door assembly 106 and the chamber body 124 and/or load lock body 424, such as using the retaining element 606. See, e.g., FIGS. 6 and 7.

At 1612, the non-limiting method 1600 can comprise maintaining adjustability of the retaining member relative to the base unit, based on flexible compliance of a retaining member holder coupled between the retaining member and the base unit, before and after the kinematic coupling of the sample support cartridge to the retaining member.

For example, before and/or after kinematic coupling of the sample support cartridge (e.g., sample support cartridge 1104) to the retaining member (e.g., position adjuster 1106) by the kinematic coupling (e.g., the first kinematic coupling elements 1206 and the second kinematic elements 1306), adjustability of the retaining member (e.g., position adjuster 1106) can be maintained, relative to the base unit (e.g., vacuum chamber body 124 and/or load lock chamber body 424) based on use of oversized holes 1308 relative to the fasteners 1310. That is, the position adjuster 1106 can be adjustability coupled (until later fixed coupling) to the flex adjuster 1108, which in turn can be coupled to the chamber door assembly 106, which in turn can be coupled to the base unit, at least by use of the rail system 438. See, e.g., FIG. 11.

At 1614, the non-limiting method 1600 can comprise causing adjustment of the sample support cartridge in at least two different degrees of freedom relative to a robotic element disposed within the base unit, wherein the two different degrees of freedom are enabled by the kinematic coupling or by use of a second kinematic coupling.

For example, adjustment of the sample support cartridge (e.g., sample support cartridge 1104) can be caused in at least two different degrees of freedom (e.g., at least two of along the X and Y directions as depicted at FIG. 5, or about the X, & or Z directions as generally depicted at FIG. 5), based on the kinematic coupling (e.g., the first kinematic coupling elements 430 and the second kinematic elements 428), relative to the robotic element (e.g., grid handling robot 128 or other automatic movement element). See, e.g., FIGS. 5 to 7.

For another example, adjustment of the sample support cartridge (e.g., sample support cartridge 1104) can be caused in at least two different degrees of freedom (e.g., at least along the X and Y directions as depicted at FIG. 13), based on the kinematic coupling (e.g., the first kinematic coupling elements 1206 and the second kinematic elements 1306), relative to the robotic element (e.g., grid handling robot 128 or other automatic movement element). See, e.g., FIG. 13.

At 1616, the non-limiting method 1600 can comprise causing adjustment of the retaining member against a resilient member disposed between the retaining member and the base unit, based on the kinematic coupling.

For example, the retaining member (e.g., door plate 432) can be adjusted against a resilient member (e.g., resilient member 426) disposed between the retaining member (e.g., door plate 432) and the base unit (e.g., vacuum chamber body 124 and/or load lock chamber body 424), based on the kinematic coupling (e.g., the first kinematic coupling elements 428 and the second kinematic elements 430). See, e.g., FIG. 6.

### Additional Summary

For simplicity of explanation, the computer-implemented and non-computer-implemented methodologies provided herein are depicted and/or described as a series of acts. It is to be understood that the subject innovation is not limited by the acts illustrated and/or by the order of acts, for example acts can occur in one or more orders and/or concurrently, and with other acts not presented and described herein. Furthermore, not all illustrated acts can be utilized to implement the computer-implemented and non-computer-implemented methodologies in accordance with the described subject matter. In addition, the computer-implemented and non-computer-implemented methodologies could alternatively be represented as a series of interrelated states via a state diagram or events. Additionally, the computer-implemented methodologies described hereinafter and throughout this specification are capable of being stored on an article of manufacture for transporting and transferring the computer-implemented methodologies to computers. The term article of manufacture, as used herein, is intended to encompass a computer program accessible from any computer-readable device or storage media.

The systems and/or devices have been (and/or will be further) described herein with respect to interaction between one or more components. Such systems and/or components can include those components or sub-components specified therein, one or more of the specified components and/or sub-components, and/or additional components. Sub-components can be implemented as components communicatively coupled to other components rather than included within parent components. One or more components and/or sub-components can be combined into a single component providing aggregate functionality. The components can interact with one or more other components not specifically described herein for the sake of brevity, but known by those of skill in the art.

In summary, embodiments described herein relate to systems and/or methods for providing positional repeatability of closure of an opening of a scientific instrument (e.g., scientific instrument 102) and/or of alignment of samples (e.g., samples 110) relative to a coordinate system (e.g., coordinate system 126) of the scientific instrument (e.g., scientific instrument 102). A system (e.g., system 104) can comprise a retaining member (e.g., door plate 432; position adjuster 1106) that receives a sample support cartridge (e.g., sample support cartridge 1104), a first portion of a kinematic coupling (e.g., first kinematic coupling elements 430 or second kinematic elements 428; first kinematic coupling elements 1206 or second kinematic elements 1306) that receives a second portion of a kinematic coupling (e.g., other of the first kinematic coupling elements 430 and second kinematic elements 428; other of the first kinematic coupling elements 1206 and second kinematic elements 1306), and the second portion of the kinematic coupling (e.g., other of the first kinematic coupling elements 430 and second kinematic elements 428; other of the first kinematic coupling elements 1206 and second kinematic elements 1306) disposed at the retaining member (e.g., door plate 432; position adjuster 1106), wherein at least the first portion of the kinematic coupling (e.g., first kinematic coupling elements 430 or second kinematic elements 428; first kinematic coupling elements 1206 or second kinematic elements 1306) or the second portion of the kinematic coupling (e.g., other of the first kinematic coupling elements 430 and second kinematic elements 428; other of the first kinematic coupling elements 1206 and second kinematic elements 1306) is disposed for joint movement with the sample support cartridge (e.g., sample support cartridge 1104) when coupled to the retaining member (e.g., door plate 432; position adjuster 1106). A system (e.g., system 104) can comprise a vacuum chamber body (e.g., vacuum chamber body 124), a vacuum chamber door (e.g., chamber door assembly 106), and a kinematic coupling (e.g., first kinematic coupling elements 430 or second kinematic elements 428; first kinematic coupling elements 1206 or second kinematic elements 1306) providing for adjustable alignment of a sample support cartridge (e.g., sample support cartridge 1104) at the vacuum chamber door (e.g., chamber door assembly 106) relative to the vacuum chamber body (e.g., vacuum chamber body 124).

The one or more embodiments described herein can employ a novel system that provides for positional repeatability of an instrument device closure, such as a door or door system with a body of the instrument device, positional repeatability of grids (e.g., lamella grids or sample grids) relative to a scientific instrument, and more particularly relative to a coordinate system of the scientific instrument, separation of degrees of freedom for providing these positional repeatabilities and/or increased sample throughput, as compared to existing frameworks.

Indeed, in view of the one or more embodiments described herein, a practical application of the one or more systems, computer-implemented methods and/or computer program products described herein can be ability to provide for consistency of engagement of an instrument door assembly with a scientific instrument, consistency of positioning of one or more grids relative to a grid-handling robot of a scientific instrument, and/or reduced preparation time prior to analysis of a set of samples at the scientific instrument.

These are useful and practical applications, thus providing enhanced (e.g., improved and/or optimized) sample analysis as compared to existing systems. Overall, such tools can constitute a concrete and tangible technical improvement in the fields of material analysis, and more particularly in material analysis using grids (e.g., lamella carriers) for transferring samples between an air side and a vacuum side of a scientific instrument.

The systems and/or devices have been (and/or will be further) described herein with respect to interaction between one or more components. Such systems and/or components can include those components or sub-components specified therein, one or more of the specified components and/or sub-components, and/or additional components. Sub-components can be implemented as components communicatively coupled to other components rather than included within parent components. One or more components and/or sub-components can be combined into a single component providing aggregate functionality. The components can interact with one or more other components not specifically described herein for the sake of brevity, but known by those of skill in the art.

In one or more embodiments, one or more of the processes described herein can be performed by one or more specialized computers (e.g., a specialized processing unit, a specialized classical computer, and/or another type of specialized computer) to execute defined tasks related to the one or more technologies describe above. One or more embodiments described herein and/or components thereof can be employed to solve new problems that arise through advancements in technologies mentioned above, employment of cloud computing systems, computer architecture and/or another technology.

One or more embodiments described herein can be fully operational towards performing one or more other functions (e.g., fully powered on, fully executed and/or another function) while also performing one or more of the one or more operations described herein.

To provide additional summary, a listing of embodiments and features thereof is next provided.

A system, comprising: a retaining member (e.g., door plate 432; position adjuster 1106) that receives a sample support cartridge (e.g., sample support cartridge 1104); a first portion of a kinematic coupling (e.g., first kinematic coupling elements 430 or second kinematic elements 428; first kinematic coupling elements 1206 or second kinematic elements 1306) that receives a second portion of a kinematic coupling (e.g., the other of the first kinematic coupling elements 430 and second kinematic elements 428; the other of the first kinematic coupling elements 1206 and the second kinematic elements 1306); and the second portion of the kinematic coupling disposed at the retaining member, wherein at least the first portion of the kinematic coupling or the second portion of the kinematic coupling is disposed for joint movement with the sample support cartridge when coupled to the retaining member.

The system of the preceding paragraph, wherein adjustability of the first portion of the kinematic coupling relative to the second portion of the kinematic coupling (e.g., first kinematic coupling elements 430 and second kinematic elements 428) is maintained after an engagement of the first portion of the kinematic coupling with the second portion of the kinematic coupling, based on flexible compliance of the retaining member (e.g., door plate 432 via material of door plate 432 and/or via oversized holes 1308).

The system of any preceding paragraph, wherein an interface between the retaining member (e.g., door plate 432; position adjuster 1106) and a retaining member holder (e.g., door carriage 434; flex adjuster 1108) is constructed to provide for adjustability of the retaining member relative to the retaining member holder after an engagement of the first portion of the kinematic coupling with the second portion of the kinematic coupling (e.g., the first kinematic coupling elements 430 and the second kinematic elements 428; the first kinematic coupling elements 1206 and the second kinematic elements 1306).

The system of any preceding paragraph, wherein the retaining member holder (e.g., door carriage 434; flex adjuster 1108) is couplable to each of the retaining member (e.g., door plate 432; position adjuster 1106) and a base unit (e.g., vacuum chamber body 124 and/or load lock chamber body 424) that receives the retaining member.

The system of any preceding paragraph, wherein the retaining member (e.g., door plate 432) is constructed to enable at least one of tilting or rotation of the retaining member against a resilient seal (e.g., elastic element 426) at a base unit (e.g., vacuum chamber body 124 and/or load lock chamber body 424), that receives the retaining member, after an engagement of the first portion of the kinematic coupling with the second portion of the kinematic coupling (e.g., the first kinematic coupling elements 430 and the second kinematic elements 428).

The system of any preceding paragraph, further comprising: a resilient member (e.g., elastic element 426) retained at the retaining member (e.g., door plate 432) or at a base unit (e.g., vacuum chamber body 124 and/or load lock chamber body 424), that receives the retaining member, wherein the resilient member maintains a vacuum seal between the retaining member and the base unit after a fixed coupling of a retaining member holder (e.g., door carriage 434) to the base unit.

The system of any preceding paragraph, further comprising: wherein adjustability of an alignment between the sample support cartridge (e.g., sample support cartridge 1104) and a base unit (e.g., vacuum chamber body 124 and/or load lock chamber body 424), that receives the retaining member (e.g., door plate 432; position adjuster 1106), is maintained after a coupling of the first portion of the kinematic coupling to the second portion of the kinematic coupling (e.g., the first kinematic coupling elements 430 and the second kinematic elements 428; the first kinematic coupling elements 1206 and the second kinematic elements 1306).

The system of any preceding paragraph, further comprising: a magnetic element set (e.g., the first magnetic element 1304 and the second magnetic element 1220) provided at the sample support cartridge (e.g., sample support cartridge 1104) and the retaining member (e.g., position adjuster 1106), wherein the magnetic element set allows for movement of the sample support cartridge in a pair of degrees of freedom (e.g., along X and Y directions depicted at FIG. 11) relative to the retaining member.

The system of any preceding paragraph, wherein the retaining member (e.g., door plate 432, position adjuster 1106) and a retaining member holder (e.g., door carriage 434; flex adjuster 1108) in combination provide for at least four degrees of freedom (e.g., X and Y directions and RX and RY directions at FIGS. 5 and 6; X, Y and Z directions and RX and RZ rotations at FIG. 11) of the sample support cartridge (e.g., sample support cartridge 1104) relative to a coordinate system of a robotic element (e.g., robotic element 128) disposed within a base unit (e.g., vacuum chamber body 124 and/or load lock chamber body 424), that receives the retaining member (e.g., door plate 432, position adjuster 1106).

The system of any preceding paragraph, wherein a first interface between the retaining member holder (e.g., door carriage 434; flex adjuster 1108) and the retaining member (e.g., door plate 432, position adjuster 1106) allows for three degrees of freedom (e.g., X and Y directions and RX or RY rotation at FIG. 5; Z direction and RX and RZ rotations at FIG. 11) of the at least four degrees of freedom, and wherein a second interface between the retaining member (e.g., door plate 432, position adjuster 1106) and the sample support cartridge (e.g., sample support cartridge 1104) allows for two degrees of freedom, of the at least four degrees of freedom.

A system, comprising: a vacuum chamber body (e.g., vacuum chamber body 124 and/or load lock chamber body 424); a vacuum chamber door (e.g., chamber door assembly 106); and a kinematic coupling (e.g., the first kinematic coupling elements 430 and the second kinematic elements 428; the first kinematic coupling elements 1206 and the second kinematic elements 1306) providing for adjustable alignment of a sample support cartridge (e.g., sample support cartridge 1104) at the vacuum chamber door relative to the vacuum chamber body.

The system of the preceding paragraph, wherein the kinematic coupling (e.g., the first kinematic coupling elements 430 and the second kinematic elements 428) provides for alignment of the vacuum chamber door (e.g., alignment of the door plate 432 of the chamber door assembly 106) relative to the vacuum chamber body (e.g., vacuum chamber body 124 and/or load lock chamber body 424) and relative to a resilient member (e.g., resilient member 426) sealing between the vacuum chamber door and the vacuum chamber body.

The system of any preceding paragraph, wherein the kinematic coupling provides for alignment of the sample support cartridge (e.g., sample support cartridge 1104) relative to the vacuum chamber door (e.g., door plate 432).

The system of any preceding paragraph, wherein the kinematic coupling (e.g., the first kinematic coupling elements 430 and the second kinematic elements 428; the first kinematic coupling elements 1206 and the second kinematic elements 1306) provides for at least a pair of degrees of freedom (e.g., X and Y directions and RZ at FIG. 5; X and Y directions at FIG. 11) of the sample support cartridge (e.g., sample support cartridge 1104) relative to the vacuum chamber body (e.g., vacuum chamber body 124 and/or load lock chamber body 424), and wherein a retaining member (e.g., position adjuster 1106; position adjuster 1106 and flex adjuster 1108) coupled between the sample support cartridge (e.g., sample support cartridge 1104) and the vacuum chamber door (e.g., door plate 432) provides for three additional degrees of freedom (e.g., Z direction and RX and RZ rotations at FIG. 11) of the sample support cartridge relative to the vacuum chamber door, other than the at least a pair of degrees of freedom.

A method, comprising: kinematically coupling a sample support cartridge (e.g., sample support cartridge 1104) to a retaining member (e.g., door plate 432, position adjuster 1106); and kinematically aligning the retaining member against a base unit (e.g., vacuum chamber body 124 and/or load lock chamber body 424) using a kinematic coupling (e.g., the first kinematic coupling elements 430 and the second kinematic elements 428; the first kinematic coupling elements 1206 and the second kinematic elements 1306) having a shape that allows for adjustability of the retaining member relative to the base unit while the kinematic coupling is engaged.

The method of the preceding paragraph, further comprising: causing the adjustability of the retaining member (e.g., door plate 432; position adjuster 1106) relative to the base unit (e.g., vacuum chamber body 124 and/or load lock chamber body 424), based on flexible compliance of a retaining member holder (e.g., door carriage 434; flex adjuster 1108) or of the retaining member (e.g., door plate 432; position adjuster 1106).

The method of any preceding paragraph, further comprising: maintaining adjustability of the retaining member (e.g., door plate 432; position adjuster 1106) relative to the base unit (e.g., vacuum chamber body 124 and/or load lock chamber body 424), based on flexible compliance of the retaining member (e.g., door plate 432; position adjuster 1106), after a kinematic coupling of the retaining member (e.g., door plate 432; position adjuster 1106) relative to the base unit (e.g., vacuum chamber body 124 and/or load lock chamber body 424).

The method of any preceding paragraph, further comprising: maintaining adjustability of the retaining member (e.g., door plate 432; position adjuster 1106) relative to the base unit (e.g., vacuum chamber body 124 and/or load lock chamber body 424), based on flexible compliance of a retaining member holder (e.g., door carriage 434; flex adjuster 1108) coupled between the retaining member (e.g., door plate 432; position adjuster 1106) and the base unit (e.g., vacuum chamber body 124 and/or load lock chamber body 424), before and after the kinematic coupling of the sample support cartridge (e.g., sample support cartridge 1104) to the retaining member (e.g., door plate 432; position adjuster 1106).

The method of any preceding paragraph, further comprising: causing adjustment of the sample support cartridge (e.g., sample support cartridge 1104) in at least two different degrees of freedom (e.g., X and Y directions and RX at FIG. 5; X and Y directions at FIG. 11) relative to a robotic element (e.g., robotic element 128) disposed within the base unit (e.g., vacuum chamber body 124 and/or load lock chamber body 424), wherein the two different degrees of freedom are enabled by the kinematic coupling (e.g., the first kinematic coupling elements 430 and the second kinematic elements 428, or the first kinematic coupling elements 1206 and the second kinematic elements 1306) or by use of a second kinematic coupling (e.g., other of the first kinematic coupling elements 430 and the second kinematic elements 428, and the first kinematic coupling elements 1206 and the second kinematic elements 1306).

The method of any preceding paragraph, further comprising: causing adjustment of the retaining member (e.g., door plate 432) against a resilient member (e.g., resilient member 426) disposed between the retaining member (e.g., door plate 432) and the base unit (e.g., vacuum chamber body 124 and/or load lock chamber body 424), based on the kinematic coupling (e.g., the first kinematic coupling elements 430 and the second kinematic elements 428, or the first kinematic coupling elements 1206 and the second kinematic elements 1306).

### Scientific Instrument System Description

Turning next to FIG. 18, a detailed description is provided of additional context for the one or more embodiments described herein at FIGS. 1-17. FIG. 18 illustrates a block diagram of an example scientific instrument system 1800 which can comprise, be the same as, employ and/or be employed by the scientific instrument 102, in accordance with various embodiments described herein. For example, the scientific instrument system 102 can be implemented by one or more of the scientific instrument 1810, the user local computing device 1820, the service local computing device 1830, and/or the remote computing device 1840 of the scientific instrument system 1800.

Any of the scientific instrument 1810, the user local computing device 1820, the service local computing device 1830, and/or the remote computing device 1840 can include any of the embodiments of the computing device 300 discussed herein with reference to FIG. 3, and any of the scientific instrument 1810, the user local computing device 1820, the service local computing device 1830, and/or the remote computing device 1840 can take the form of any appropriate one or more of the embodiments of the computing device 300 discussed herein with reference to FIG. 3.

One or more of the scientific instrument 1810, the user local computing device 1820, the service local computing device 1830, and/or the remote computing device 1840 can include a processing device 1802, a storage device 1804, and/or an interface device 1806. The processing device 1802 can take any suitable form, including the form of any of the processors 302 discussed herein with reference to FIG. 3. The processing devices 1802 included in different ones of the scientific instrument 1810, the user local computing device 1820, the service local computing device 1830, and/or the remote computing device 1840 can take the same form or different forms. The storage device 1804 can take any suitable form, including the form of any of the storage devices 304 discussed herein with reference to FIG. 3. The storage devices 1804 included in different ones of the scientific instrument 1810, the user local computing device 1820, the service local computing device 1830, and/or the remote computing device 1840 can take the same form or different forms. The interface device 1806 can take any suitable form, including the form of any of the interface devices 306 discussed herein with reference to FIG. 3. The interface devices 306 included in different ones of the scientific instrument 1810, the user local computing device 1820, the service local computing device 1830, and/or the remote computing device 1840 can take the same form or different forms.

The scientific instrument 1810, the user local computing device 1820, the service local computing device 1830, and/or the remote computing device 1840 can be in communication with other elements of the scientific instrument system 1800 via communication pathways 1808. The communication pathways 1808 can communicatively couple the interface devices 1806 of different ones of the elements of the scientific instrument system 1800, as shown, and can be wired or wireless communication pathways (e.g., in accordance with any of the communication techniques discussed herein with reference to the interface devices 306 of the computing device 300 of FIG. 3). The particular scientific instrument system 1800 depicted in FIG. 18 includes communication pathways between each pair of the scientific instrument 1810, the user local computing device 1820, the service local computing device 1830, and the remote computing device 1840, but this "fully connected" implementation is simply illustrative, and in various embodiments, various ones of the communication pathways 1808 can be omitted. For example, in one or more embodiments, a service local computing device 1830 can omit a direct communication pathway 1808 between its interface device 1806 and the interface device 1806 of the scientific instrument 1810, but can instead communicate with the scientific instrument 1810 via the communication pathway 1808 between the service local computing device 1830 and the user local computing device 1820 and/or the communication pathway 1808 between the user local computing device 1820 and the scientific instrument 1810.

The scientific instrument 1810 can include any appropriate scientific instrument, such as a separation or MS instrument, or other instrument facilitating material analysis.

The user local computing device 1820 can be a computing device (e.g., in accordance with any of the embodiments of the computing device 300 discussed herein) that is local to a user of the scientific instrument 1810. In one or more embodiments, the user local computing device 1820 can also be local to the scientific instrument 1810, but this need not be the case; for example, a user local computing device 1820 that is associated with a home, office or other building associated with a user entity can be remote from, but in communication with, the scientific instrument 1810 so that the user entity can use the user local computing device 1820 to control and/or access data from the scientific instrument 1810. In one or more embodiments, the user local computing device 1820 can be a laptop, smartphone, or tablet device. In one or more embodiments the user local computing device 1820 can be a portable computing device. In one or more embodiments, the user local computing device 1820 can deployed in the field.

The service local computing device 1830 can be a computing device (e.g., in accordance with any of the embodiments of the computing device 300 discussed herein) that is local to an entity that services the scientific instrument 1810. For example, the service local computing device 1830 can be local to a manufacturer of the scientific instrument 1810 or to a third-party service company. In one or more embodiments, the service local computing device 1830 can communicate with the scientific instrument 1810, the user local computing device 1820, and/or the remote computing device 1840 (e.g., via a direct communication pathway 1808 or via multiple "indirect" communication pathways 1808, as discussed above) to receive data regarding the operation of the scientific instrument 1810, the user local computing device 1820, and/or the remote computing device 1840 (e.g., the results of self-tests of the scientific instrument 1810, calibration coefficients used by the scientific instrument 1810, the measurements of sensors associated with the scientific instrument 1810, etc.). In one or more embodiments, the service local computing device 1830 can communicate with the scientific instrument 1810, the user local computing device 1820, and/or the remote computing device 1840 (e.g., via a direct communication pathway 1808 or via multiple "indirect" communication pathways 1808, as discussed above) to transmit data to the scientific instrument 1810, the user local computing device 1820, and/or the remote computing device 1840 (e.g., to update programmed instructions, such as firmware, in the scientific instrument 1810, to initiate the performance of test or calibration sequences in the scientific instrument 1810, to update programmed instructions, such as software, in the user local computing device 1820 or the remote computing device 1840, etc.). A user entity of the scientific instrument 1810 can utilize the scientific instrument 1810 or the user local computing device 1820 to communicate with the service local computing device 1830 to report a problem with the scientific instrument 1810 or the user local computing device 1820, to request a visit from a technician to improve the operation of the scientific instrument 1810, to order consumables or replacement parts associated with the scientific instrument 1810, or for other purposes.

The remote computing device 1840 can be a computing device (e.g., in accordance with any of the embodiments of the computing device 300 discussed herein) that is remote from the scientific instrument 1810 and/or from the user local computing device 1820. In one or more embodiments, the remote computing device 1840 can be included in a datacenter or other large-scale server environment. In one or more embodiments, the remote computing device 1840 can include network-attached storage (e.g., as part of the storage device 1804). The remote computing device 1840 can store data generated by the scientific instrument 1810, perform analyses of the data generated by the scientific instrument 1810 (e.g., in accordance with programmed instructions), facilitate communication between the user local computing device 1820 and the scientific instrument 1810, and/or facilitate communication between the service local computing device 1830 and the scientific instrument 1810.

In one or more embodiments, one or more of the elements of the scientific instrument system 1800 illustrated in FIG. 18 can be omitted. Further, in one or more embodiments, multiple ones of various ones of the elements of the scientific instrument system 1800 of FIG. 18 can be present. For example, a scientific instrument system 1800 can include multiple user local computing devices 1820 (e.g., different user local computing devices 1820 associated with different user entities or in different locations). In another example, a scientific instrument system 1800 can include multiple scientific instruments 1810, all in communication with service local computing device 1830 and/or a remote computing device 1840; in such an embodiment, the service local computing device 1830 can monitor these multiple scientific instruments 1810, and the service local computing device 1830 can cause updates or other information can be "broadcast" to multiple scientific instruments 1810 at the same time. Different ones of the scientific instruments 1810 in a scientific instrument system 1800 can be located close to one another (e.g., in the same room) or farther from one another (e.g., on different floors of a building, in different buildings, in different cities, etc.). In one or more embodiments, a scientific instrument 1810 can be connected to an Internet-of-Things (IoT) stack that allows for command and control of the scientific instrument 1810 through a web-based application, a virtual or augmented reality application, a mobile application, and/or a desktop application. Any of these applications can be accessed by a user entity operating the user local computing device 1820 in communication with the scientific instrument 1810 by the intervening remote computing device 1840. In one or more embodiments, a scientific instrument 1810 can be sold by the manufacturer along with one or more associated user local computing devices 1820 as part of a local scientific instrument computing unit 1812.

In one or more embodiments, different ones of the scientific instruments 1810 included in a scientific instrument system 1800 can be different types of scientific instruments 1810; for example, one scientific instrument 1810 can be an EDS device, while another scientific instrument 1810 can be an analysis device that analyzes results of an EDS device. In some such embodiments, the remote computing device 1840 and/or the user local computing device 1820 can combine data from different types of scientific instruments 1810 included in a scientific instrument system 1800.

### Example Operating Environment

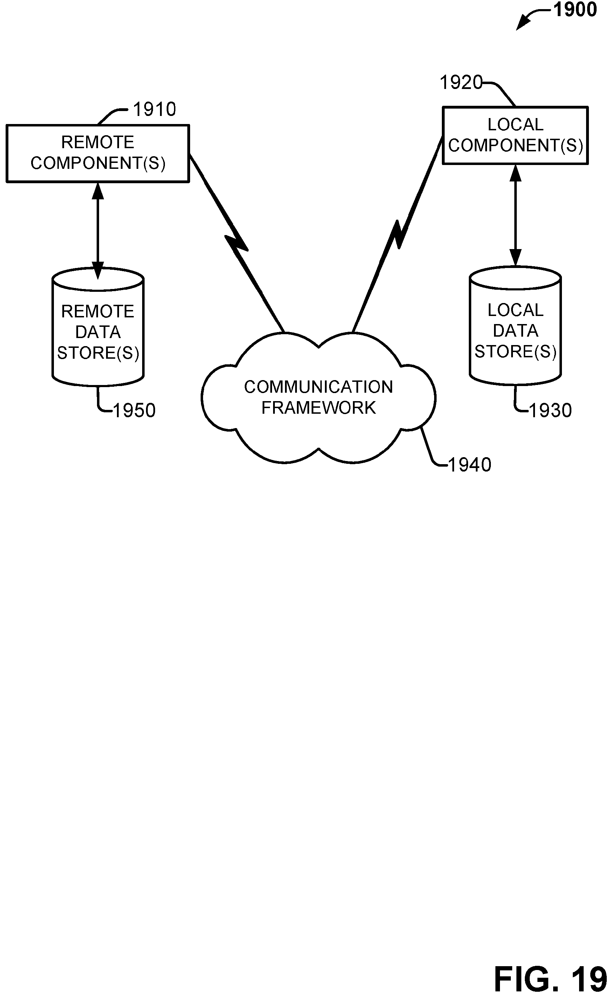

FIG. 19 is a schematic block diagram of an operating environment 1900 with which the described subject matter can interact. The operating environment 1900 comprises one or more remote component(s) 1910. The remote component(s) 1910 can be hardware and/or software (e.g., threads, processes, computing devices). In one or more embodiments, remote component(s) 1910 can be a distributed computer system, connected to a local automatic scaling component and/or programs that use the resources of a distributed computer system, via communication framework 1940. Communication framework 1940 can comprise wired network devices, wireless network devices, mobile devices, wearable devices, radio access network devices, gateway devices, femtocell devices, servers, etc.

The operating environment 1900 also comprises one or more local component(s) 1920. The local component(s) 1920 can be hardware and/or software (e.g., threads, processes, computing devices). In one or more embodiments, local component(s) 1920 can comprise an automatic scaling component and/or programs that communicate/use the remote resources 1910 and 1920, etc., connected to a remotely located distributed computing system via communication framework 1940.

One possible communication between a remote component(s) 1910 and a local component(s) 1920 can be in the form of a data packet adapted to be transmitted between two or more computer processes. Another possible communication between a remote component(s) 1910 and a local component(s) 1920 can be in the form of circuit-switched data adapted to be transmitted between two or more computer processes in radio time slots. The operating environment 1900 comprises a communication framework 1940 that can be employed to facilitate communications between the remote component(s) 1910 and the local component(s) 1920, and can comprise an air interface, e.g., interface of a UMTS network, via an LTE network, etc. Remote component(s) 1910 can be operably connected to one or more remote datastore(s) 1950, such as a hard drive, solid state drive, subscriber identity module (SIM) card, electronic SIM (eSIM), device memory, etc., that can be employed to store information on the remote component(s) 1910 side of communication framework 1940. Similarly, local component(s) 1920 can be operably connected to one or more local datastore(s) 1930, that can be employed to store information on the local component(s) 1920 side of communication framework 1940.

### Example Computing Environment

In order to provide additional context for various embodiments described herein, FIG. 20 and the following discussion are intended to provide a brief, general description of a suitable computing environment 2000 in which the various embodiments of the embodiment described herein can be implemented. While the embodiments have been described above in the general context of computer-executable instructions that can run on one or more computers, those skilled in the art will recognize that the embodiments can be also implemented in combination with other program modules and/or as a combination of hardware and software.

Generally, program modules include routines, programs, components, data structures, etc., that perform tasks or implement abstract data types. Moreover, the methods can be practiced with other computer system configurations, including single-processor or multiprocessor computer systems, minicomputers, mainframe computers, Internet of Things (IoT) devices, distributed computing systems, as well as personal computers, hand-held computing devices, microprocessor-based or programmable consumer electronics, and the like, each of which can be operatively coupled to one or more associated devices.

The illustrated embodiments of the embodiments herein can also be practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, and/or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data, or unstructured data.

Computer-readable storage media can include, but are not limited to, random access memory (RAM), read only memory (ROM), electrically erasable programmable read only memory (EEPROM), flash memory or other memory technology, compact disk read only memory (CD ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible and/or non-transitory media which can be used to store desired information. In this regard, the terms "tangible" or "non-transitory" herein as applied to storage, memory, or computer-readable media, exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries, or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or directwired connection, and wireless media such as acoustic, RF, infrared and other wireless media.

Referring still to FIG. 20, the example computing environment 2000 which can implement one or more embodiments described herein includes a computer 2002, the computer 2002 including a processing unit 2004, a system memory 2006 and a system bus 2008. The system bus 2008 couples system components including, but not limited to, the system memory 2006 to the processing unit 2004. The processing unit 2004 can be any of various commercially available processors. Dual microprocessors and other multi processor architectures can also be employed as the processing unit 2004.

The system bus 2008 can be any of several types of bus structure that can further interconnect to a memory bus (with or without a memory controller), a peripheral bus, and a local bus using any of a variety of commercially available bus architectures. The system memory 2006 includes ROM 2010 and RAM 2012. A basic input/output system (BIOS) can be stored in a non-volatile memory such as ROM, erasable programmable read only memory (EPROM), EEPROM, which BIOS contains the basic routines that help to transfer information between elements within the computer 2002, such as during startup. The RAM 2012 can also include a high-speed RAM such as static RAM for caching data.

The computer 2002 further includes an internal hard disk drive (HDD) 2014 (e.g., EIDE, SATA), and can include one or more external storage devices 2016 (e.g., a magnetic floppy disk drive (FDD) 2016, a memory stick or flash drive reader, a memory card reader, etc.). While the internal HDD 2014 is illustrated as located within the computer 2002, the internal HDD 2014 can also be configured for external use in a suitable chassis (not shown). Additionally, while not shown in computing environment 2000, a solid-state drive (SSD) could be used in addition to, or in place of, an HDD 2014.

Other internal or external storage can include at least one other storage device 2020 with storage media 2022 (e.g., a solid-state storage device, a nonvolatile memory device, and/or an optical disk drive that can read or write from removable media such as a CD-ROM disc, a DVD, a BD, etc.). The external storage 2016 can be facilitated by a network virtual machine. The HDD 2014, external storage device 2016 and storage device (e.g., drive) 2020 can be connected to the system bus 2008 by an HDD interface 2024, an external storage interface 2026 and a drive interface 2028, respectively.

The drives and their associated computer-readable storage media provide nonvolatile storage of data, data structures, computer-executable instructions, and so forth. For the computer 2002, the drives and storage media accommodate the storage of any data in a suitable digital format. Although the description of computer-readable storage media above refers to respective types of storage devices, other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 2012, including an operating system 2030, one or more application programs 2032, other program modules 2034 and program data 2036. All or portions of the operating system, applications, modules, and/or data can also be cached in the RAM 2012. The systems and methods described herein can be implemented utilizing various commercially available operating systems or combinations of operating systems.

Computer 2002 can optionally comprise emulation technologies. For example, a hypervisor (not shown) or other intermediary can emulate a hardware environment for operating system 2030, and the emulated hardware can optionally be different from the hardware illustrated in FIG. 20. In such an embodiment, operating system 2030 can comprise one virtual machine (VM) of multiple VMs hosted at computer 2002. Furthermore, operating system 2030 can provide runtime environments, such as the Java runtime environment or the .NET framework, for applications 2032. Runtime environments are consistent execution environments that allow applications 2032 to run on any operating system that includes the runtime environment. Similarly, operating system 2030 can support containers, and applications 2032 can be in the form of containers, which are lightweight, standalone, executable packages of software that include, e.g., code, runtime, system tools, system libraries and settings for an application.

Further, computer 2002 can be enabled with a security module, such as a trusted processing module (TPM). For instance, with a TPM, boot components hash next in time boot components, and wait for a match of results to secured values, before loading a next boot component. This process can take place at any layer in the code execution stack of computer 2002, e.g., applied at the application execution level or at the operating system (OS) kernel level, thereby enabling security at any level of code execution.

A user entity can enter commands and information into the computer 2002 through one or more wired/wireless input devices, e.g., a keyboard 2038, a touch screen 2040, and a pointing device, such as a mouse 2042. Other input devices (not shown) can include a microphone, an infrared (IR) remote control, a radio frequency (RF) remote control, or other remote control, a joystick, a virtual reality controller and/or virtual reality headset, a game pad, a stylus pen, an image input device, e.g., camera, a gesture sensor input device, a vision movement sensor input device, an emotion or facial detection device, a biometric input device, e.g., fingerprint or iris scanner, or the like. These and other input devices are often connected to the processing unit 2004 through an input device interface 2044 that can be coupled to the system bus 2008, but can be connected by other interfaces, such as a parallel port, an IEEE 1394 serial port, a game port, a USB port, an IR interface, a BLUETOOTH^{®} interface, etc.

A monitor 2046 or other type of display device can also be connected to the system bus 2008 via an interface, such as a video adapter 2048. In addition to the monitor 2046, a computer typically includes other peripheral output devices (not shown), such as speakers, printers, etc.

The computer 2002 can operate in a networked environment using logical connections via wired and/or wireless communications to one or more remote computers, such as a remote computer 2050. The remote computer 2050 can be a workstation, a server computer, a router, a personal computer, portable computer, microprocessor-based entertainment appliance, a peer device or other common network node, and typically includes many or all of the elements described relative to the computer 2002, although, for purposes of brevity, only a memory/storage device 2052 is illustrated. The logical connections depicted include wired/wireless connectivity to a local area network (LAN) 2054 and/or larger networks, e.g., a wide area network (WAN) 2056. Such LAN and WAN networking environments are commonplace in offices and companies, and facilitate enterprise-wide computer networks, such as intranets, all of which can connect to a global communications network, e.g., the Internet.

When used in a LAN networking environment, the computer 2002 can be connected to the local network 2054 through a wired and/or wireless communication network interface or adapter 2058. The adapter 2058 can facilitate wired or wireless communication to the LAN 2054, which can also include a wireless access point (AP) disposed thereon for communicating with the adapter 2058 in a wireless mode.

When used in a WAN networking environment, the computer 2002 can include a modem 2060 or can be connected to a communications server on the WAN 2056 via other means for establishing communications over the WAN 2056, such as by way of the Internet. The modem 2060, which can be internal or external and a wired or wireless device, can be connected to the system bus 2008 via the input device interface 2044. In a networked environment, program modules depicted relative to the computer 2002 or portions thereof, can be stored in the remote memory/storage device 2052. The network connections shown are example and other means of establishing a communications link between the computers can be used.

When used in either a LAN or WAN networking environment, the computer 2002 can access cloud storage systems or other network-based storage systems in addition to, or in place of, external storage devices 2016 as described above. Generally, a connection between the computer 2002 and a cloud storage system can be established over a LAN 2054 or WAN 2056 e.g., by the adapter 2058 or modem 2060, respectively. Upon connecting the computer 2002 to an associated cloud storage system, the external storage interface 2026 can, with the aid of the adapter 2058 and/or modem 2060, manage storage provided by the cloud storage system as it would other types of external storage. For instance, the external storage interface 2026 can be configured to provide access to cloud storage sources as if those sources were physically connected to the computer 2002.

The computer 2002 can be operable to communicate with any wireless devices or entities operatively disposed in wireless communication, e.g., a printer, scanner, desktop and/or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH^{®} wireless technologies. Thus, the communication can be a defined structure as with an existing network or simply an ad hoc communication between at least two devices.

### Additional Information

The embodiments described herein can be directed to one or more of a system, a method, an apparatus and/or a computer program product at any possible technical detail level of integration. The computer program product can include a computer readable storage medium (or media) having computer readable program instructions thereon for causing a processor to carry out aspects of the one or more embodiments described herein. The computer readable storage medium can be a tangible device that can retain and store instructions for use by an instruction execution device. The computer readable storage medium can be, for example, but is not limited to, an electronic storage device, a magnetic storage device, an optical storage device, an electromagnetic storage device, a superconducting storage device and/or any suitable combination of the foregoing. A non-exhaustive list of more specific examples of the computer readable storage medium can also include the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon and/or any suitable combination of the foregoing. A computer readable storage medium, as used herein, is not to be construed as being transitory signals per se, such as radio waves and/or other freely propagating electromagnetic waves, electromagnetic waves propagating through a waveguide and/or other transmission media (e.g., light pulses passing through a fiber-optic cable), and/or electrical signals transmitted through a wire.

Computer readable program instructions described herein can be downloaded to respective computing/processing devices from a computer readable storage medium and/or to an external computer or external storage device via a network, for example, the Internet, a local area network, a wide area network and/or a wireless network. The network can comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of the one or more embodiments described herein can be assembler instructions, instruction-set-architecture (ISA) instructions, machine instructions, machine dependent instructions, microcode, firmware instructions, statesetting data, configuration data for integrated circuitry, and/or source code and/or object code written in any combination of one or more programming languages, including an object oriented programming language such as Smalltalk, C++ or the like, and/or procedural programming languages, such as the "C" programming language and/or similar programming languages. The computer readable program instructions can execute entirely on a computer, partly on a computer, as a stand-alone software package, partly on a computer and/or partly on a remote computer or entirely on the remote computer and/or server. In the latter scenario, the remote computer can be connected to a computer through any type of network, including a local area network (LAN) and/or a wide area network (WAN), and/or the connection can be made to an external computer (for example, through the Internet using an Internet Service Provider). In one or more embodiments, electronic circuitry including, for example, programmable logic circuitry, field-programmable gate arrays (FPGA) and/or programmable logic arrays (PLA) can execute the computer readable program instructions by utilizing state information of the computer readable program instructions to personalize the electronic circuitry, in order to perform aspects of the one or more embodiments described herein.

Aspects of the one or more embodiments described herein are described with reference to flowchart illustrations and/or block diagrams of methods, apparatus (systems), and computer program products according to one or more embodiments described herein. It will be understood that each block of the flowchart illustrations and/or block diagrams, and combinations of blocks in the flowchart illustrations and/or block diagrams, can be implemented by computer readable program instructions. These computer readable program instructions can be provided to a processor of a generalpurpose computer, special purpose computer and/or other programmable data processing apparatus to produce a machine, such that the instructions, which execute via the processor of the computer or other programmable data processing apparatus, can create means for implementing the functions/acts specified in the flowchart and/or block diagram block or blocks. These computer readable program instructions can also be stored in a computer readable storage medium that can direct a computer, a programmable data processing apparatus and/or other devices to function in a particular manner, such that the computer readable storage medium having instructions stored therein can comprise an article of manufacture including instructions which can implement aspects of the function/act specified in the flowchart and/or block diagram block or blocks. The computer readable program instructions can also be loaded onto a computer, other programmable data processing apparatus and/or other device to cause a series of operational acts to be performed on the computer, other programmable apparatus and/or other device to produce a computer implemented process, such that the instructions which execute on the computer, other programmable apparatus and/or other device implement the functions/acts specified in the flowchart and/or block diagram block or blocks.

The flowcharts and block diagrams in the figures illustrate the architecture, functionality and/or operation of possible implementations of systems, computerimplementable methods and/or computer program products according to one or more embodiments described herein. In this regard, each block in the flowchart or block diagrams can represent a module, segment and/or portion of instructions, which comprises one or more executable instructions for implementing the specified logical function. In one or more alternative implementations, the functions noted in the blocks can occur out of the order noted in the Figures. For example, two blocks shown in succession can be executed substantially concurrently, and/or the blocks can sometimes be executed in the reverse order, depending upon the functionality involved. It will also be noted that each block of the block diagrams and/or flowchart illustration, and/or combinations of blocks in the block diagrams and/or flowchart illustration, can be implemented by special purpose hardware-based systems that can perform the specified functions and/or acts and/or carry out one or more combinations of special purpose hardware and/or computer instructions.

While the subject matter has been described above in the general context of computer-executable instructions of a computer program product that runs on a computer and/or computers, those skilled in the art will recognize that the one or more embodiments herein also can be implemented at least partially in parallel with one or more other program modules. Generally, program modules include routines, programs, components and/or data structures that perform particular tasks and/or implement particular abstract data types. Moreover, the aforedescribed computer-implemented methods can be practiced with other computer system configurations, including single-processor and/or multiprocessor computer systems, mini-computing devices, mainframe computers, as well as computers, hand-held computing devices (e.g., PDA, phone), and/or microprocessor-based or programmable consumer and/or industrial electronics. The illustrated aspects can also be practiced in distributed computing environments in which tasks are performed by remote processing devices that are linked through a communications network. However, one or more, if not all aspects of the one or more embodiments described herein can be practiced on stand-alone computers. In a distributed computing environment, program modules can be located in both local and remote memory storage devices.

As used in this application, the terms "component," "system," "platform" and/or "interface" can refer to and/or can include a computer-related entity or an entity related to an operational machine with one or more specific functionalities. The entities described herein can be either hardware, a combination of hardware and software, software, or software in execution. For example, a component can be, but is not limited to being, a process running on a processor, a processor, an object, an executable, a thread of execution, a program and/or a computer. By way of illustration, both an application running on a server and the server can be a component. One or more components can reside within a process and/or thread of execution and a component can be localized on one computer and/or distributed between two or more computers. In another example, respective components can execute from various computer readable media having various data structures stored thereon. The components can communicate via local and/or remote processes such as in accordance with a signal having one or more data packets (e.g., data from one component interacting with another component in a local system, distributed system and/or across a network such as the Internet with other systems via the signal). As another example, a component can be an apparatus with specific functionality provided by mechanical parts operated by electric or electronic circuitry, which is operated by a software and/or firmware application executed by a processor. In such a case, the processor can be internal and/or external to the apparatus and can execute at least a part of the software and/or firmware application. As yet another example, a component can be an apparatus that provides specific functionality through electronic components without mechanical parts, where the electronic components can include a processor and/or other means to execute software and/or firmware that confers at least in part the functionality of the electronic components. In an aspect, a component can emulate an electronic component via a virtual machine, e.g., within a cloud computing system.

In addition, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. Moreover, articles "a" and "an" as used in the subject specification and annexed drawings should generally be construed to mean "one or more" unless specified otherwise or clear from context to be directed to a singular form. As used herein, the terms "example" and/or "exemplary" are utilized to mean serving as an example, instance, or illustration. For the avoidance of doubt, the subject matter described herein is not limited by such examples. In addition, any aspect or design described herein as an "example" and/or "exemplary" is not necessarily to be construed as preferred or advantageous over other aspects or designs, nor is it meant to preclude equivalent exemplary structures and techniques known to those of ordinary skill in the art.

As it is employed in the subject specification, the term "processor" can refer to substantially any computing processing unit and/or device comprising, but not limited to, single-core processors; single-processors with software multithread execution capability; multi-core processors; multi-core processors with software multithread execution capability; multi-core processors with hardware multithread technology; parallel platforms; and/or parallel platforms with distributed shared memory. Additionally, a processor can refer to an integrated circuit, an application specific integrated circuit (ASIC), a digital signal processor (DSP), a field programmable gate array (FPGA), a programmable logic controller (PLC), a complex programmable logic device (CPLD), a discrete gate or transistor logic, discrete hardware components, and/or any combination thereof designed to perform the functions described herein. Further, processors can exploit nano-scale architectures such as, but not limited to, molecular based transistors, switches and/or gates, in order to optimize space usage and/or to enhance performance of related equipment. A processor can be implemented as a combination of computing processing units.

Herein, terms such as "store," "storage," "datastore," data storage," "database," and substantially any other information storage component relevant to operation and functionality of a component are utilized to refer to "memory components," entities embodied in a "memory," or components comprising a memory. Memory and/or memory components described herein can be either volatile memory or nonvolatile memory or can include both volatile and nonvolatile memory. By way of illustration, and not limitation, nonvolatile memory can include read only memory (ROM), programmable ROM (PROM), electrically programmable ROM (EPROM), electrically erasable ROM (EEPROM), flash memory and/or nonvolatile random-access memory (RAM) (e.g., ferroelectric RAM (FeRAM). Volatile memory can include RAM, which can act as external cache memory, for example. By way of illustration and not limitation, RAM can be available in many forms such as synchronous RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), direct Rambus RAM (DRRAM), direct Rambus dynamic RAM (DRDRAM) and/or Rambus dynamic RAM (RDRAM). Additionally, the described memory components of systems and/or computer-implemented methods herein are intended to include, without being limited to including, these and/or any other suitable types of memory.

What has been described above includes mere examples of systems and computer-implemented methods. It is, of course, not possible to describe every conceivable combination of components and/or computer-implemented methods for purposes of describing the one or more embodiments, but one of ordinary skill in the art can recognize that many further combinations and/or permutations of the one or more embodiments are possible. Furthermore, to the extent that the terms "includes," "has," "possesses," and the like are used in the detailed description, claims, appendices and/or drawings such terms are intended to be inclusive in a manner similar to the term "comprising" as "comprising" is interpreted when employed as a transitional word in a claim.

The descriptions of the various embodiments can use the phrases "an embodiment," "various embodiments," "one or more embodiments" and/or "some embodiments," each of which can refer to one or more of the same or different embodiments.

The descriptions of the various embodiments have been presented for purposes of illustration but are not intended to be exhaustive or limited to the embodiments described herein. Many modifications and variations will be apparent to those of ordinary skill in the art without departing from the scope and spirit of the described embodiments. The terminology used herein was chosen to best explain the principles of the embodiments, the practical application and/or technical improvement over technologies found in the marketplace, and/or to enable others of ordinary skill in the art to understand the embodiments described herein.

Aspects of the invention may be defined by the following numbered clauses.

Clause 1. A system, comprising: a retaining member that receives a sample support cartridge; a first portion of a kinematic coupling that receives a second portion of a kinematic coupling; and the second portion of the kinematic coupling disposed at the retaining member, wherein at least the first portion of the kinematic coupling or the second portion of the kinematic coupling is disposed for joint movement with the sample support cartridge when coupled to the retaining member.

Clause 2. The system of clause 1, wherein adjustability of the first portion of the kinematic coupling relative to the second portion of the kinematic coupling is maintained after an engagement of the first portion of the kinematic coupling with the second portion of the kinematic coupling, based on flexible compliance of the retaining member.

Clause 3. The system of clause 1, wherein an interface between the retaining member and a retaining member holder is constructed to provide for adjustability of the retaining member relative to the retaining member holder after an engagement of the first portion of the kinematic coupling with the second portion of the kinematic coupling.

Clause 4. The system of clause 3,
wherein the retaining member holder is couplable to each of the retaining member and a base unit that receives the retaining member.

Clause 5. The system of clause 1, wherein the retaining member is constructed to enable at least one of tilting or rotation of the retaining member against a resilient seal at a base unit, that receives the retaining member, after an engagement of the first portion of the kinematic coupling with the second portion of the kinematic coupling.

Clause 6. The system of clause 1, further comprising: a resilient member retained at the retaining member or at a base unit, that receives the retaining member, wherein the resilient member maintains a vacuum seal between the retaining member and the base unit after a fixed coupling of a retaining member holder to the base unit.

Clause 7. The system of clause 1, further comprising: wherein adjustability of an alignment between the sample support cartridge and a base unit, that receives the retaining member, is maintained after a coupling of the first portion of the kinematic coupling to the second portion of the kinematic coupling.

Clause 8. The system of clause 1, further comprising: a magnetic element set provided at the sample support cartridge and the retaining member, wherein the magnetic element set allows for movement of the sample support cartridge in a pair of degrees of freedom relative to the retaining member.

Clause 9. The system of clause 1, wherein the retaining member and a retaining member holder in combination provide for at least four degrees of freedom of the sample support cartridge relative to a coordinate system of a robotic element disposed within a base unit, that receives the retaining member.

Clause 10. The system of clause 9, wherein a first interface between the retaining member holder and the retaining member allows for three degrees of freedom of the at least four degrees of freedom, and wherein a second interface between the retaining member and the sample support cartridge allows for two degrees of freedom, of the at least four degrees of freedom.

Clause 11. A system, comprising: a vacuum chamber body; a vacuum chamber door; and a kinematic coupling providing for adjustable alignment of a sample support cartridge at the vacuum chamber door relative to the vacuum chamber body.

Clause 12. The system of clause 11, wherein the kinematic coupling provides for alignment of the vacuum chamber door relative to the vacuum chamber body and relative to a resilient member sealing between the vacuum chamber door and the vacuum chamber body.

Clause 13. The system of clause 11, wherein the kinematic coupling provides for alignment of the sample support cartridge relative to the vacuum chamber door.

Clause 14. The system of clause 11, wherein the kinematic coupling provides for at least a pair of degrees of freedom of the sample support cartridge relative to the vacuum chamber body, and wherein a retaining member coupled between the sample support cartridge and the vacuum chamber door provides for three additional degrees of freedom of the sample support cartridge relative to the vacuum chamber door, other than the at least a pair of degrees of freedom.

Clause 15. A method, comprising: kinematically coupling a sample support cartridge to a retaining member; and kinematically aligning the retaining member against a base unit using a kinematic coupling having a shape that allows for adjustability of the retaining member relative to the base unit while the kinematic coupling is engaged.

Clause 16. The method of clause 15, further comprising: causing the adjustability of the retaining member relative to the base unit, based on flexible compliance of a retaining member holder or of the retaining member.

Clause 17. The method of clause 15, further comprising: maintaining adjustability of the retaining member relative to the base unit, based on flexible compliance of the retaining member, after a kinematic coupling of the retaining member relative to the base unit.

Clause 18. The method of clause 15, further comprising: maintaining adjustability of the retaining member relative to the base unit, based on flexible compliance of a retaining member holder coupled between the retaining member and the base unit, before and after the kinematic coupling of the sample support cartridge to the retaining member.

Clause 19. The method of clause 15, further comprising: causing adjustment of the sample support cartridge in at least two different degrees of freedom relative to a robotic element disposed within the base unit, wherein the two different degrees of freedom are enabled by the kinematic coupling or by use of a second kinematic coupling.

Clause 20. The method of clause 15, further comprising: causing adjustment of the retaining member against a resilient member disposed between the retaining member and the base unit, based on the kinematic coupling.

## Claims

1. A system, comprising:
a retaining member that receives a sample support cartridge;
a first portion of a kinematic coupling that receives a second portion of a kinematic coupling; and
the second portion of the kinematic coupling disposed at the retaining member,
wherein at least the first portion of the kinematic coupling or the second portion of the kinematic coupling is disposed for joint movement with the sample support cartridge when coupled to the retaining member.

2. The system of claim 1,
wherein adjustability of the first portion of the kinematic coupling relative to the second portion of the kinematic coupling is maintained after an engagement of the first portion of the kinematic coupling with the second portion of the kinematic coupling, based on flexible compliance of the retaining member.

3. The system of any of claims 1 to 2,
wherein an interface between the retaining member and a retaining member holder is constructed to provide for adjustability of the retaining member relative to the retaining member holder after an engagement of the first portion of the kinematic coupling with the second portion of the kinematic coupling; and optionally
wherein the retaining member holder is couplable to each of the retaining member and a base unit that receives the retaining member.

4. The system of any of claims 1 to 3,
wherein the retaining member is constructed to enable at least one of tilting or rotation of the retaining member against a resilient seal at a base unit, that receives the retaining member, after an engagement of the first portion of the kinematic coupling with the second portion of the kinematic coupling.

5. The system of any of claims 1 to 4, further comprising:
a resilient member retained at the retaining member or at a base unit, that receives the retaining member,
wherein the resilient member maintains a vacuum seal between the retaining member and the base unit after a fixed coupling of a retaining member holder to the base unit.

6. The system of any of claims 1 to 5, further comprising:
wherein adjustability of an alignment between the sample support cartridge and a base unit, that receives the retaining member, is maintained after a coupling of the first portion of the kinematic coupling to the second portion of the kinematic coupling.

7. The system of any of claims 1 to 6, further comprising:
a magnetic element set provided at the sample support cartridge and the retaining member,
wherein the magnetic element set allows for movement of the sample support cartridge in a pair of degrees of freedom relative to the retaining member.

8. The system of any of claims 1 to 7,
wherein the retaining member and a retaining member holder in combination provide for at least four degrees of freedom of the sample support cartridge relative to a coordinate system of a robotic element disposed within a base unit, that receives the retaining member; and optionally wherein:
a first interface between the retaining member holder and the retaining member allows for three degrees of freedom of the at least four degrees of freedom, and
a second interface between the retaining member and the sample support cartridge allows for two degrees of freedom, of the at least four degrees of freedom.

9. A system according to any of claims 1 to 8, further comprising:
a vacuum chamber body; and
a vacuum chamber door..

10. The system of claim 9,
wherein the kinematic coupling provides for alignment of the vacuum chamber door relative to the vacuum chamber body and relative to a resilient member sealing between the vacuum chamber door and the vacuum chamber body.

11. The system of any of claims 9 to 10,
wherein the kinematic coupling provides for alignment of the sample support cartridge relative to the vacuum chamber door.

12. The system of any of claims 9 to 11,
wherein the kinematic coupling provides for at least a pair of degrees of freedom of the sample support cartridge relative to the vacuum chamber body, and
wherein a retaining member coupled between the sample support cartridge and the vacuum chamber door provides for three additional degrees of freedom of the sample support cartridge relative to the vacuum chamber door, other than the at least a pair of degrees of freedom.

13. A method, comprising:
kinematically coupling a sample support cartridge to a retaining member; and
kinematically aligning the retaining member against a base unit using a kinematic coupling having a shape that allows for adjustability of the retaining member relative to the base unit while the kinematic coupling is engaged.

14. The method of claim 13, further comprising:
causing the adjustability of the retaining member relative to the base unit, based on flexible compliance of a retaining member holder or of the retaining member; and optionally:
maintaining adjustability of the retaining member relative to the base unit, based on flexible compliance of the retaining member, after a kinematic coupling of the retaining member relative to the base unit; or
maintaining adjustability of the retaining member relative to the base unit, based on flexible compliance of a retaining member holder coupled between the retaining member and the base unit, before and after the kinematic coupling of the sample support cartridge to the retaining member.

15. The method of any of claims 13 or 14, further comprising:
causing adjustment of the sample support cartridge in at least two different degrees of freedom relative to a robotic element disposed within the base unit, wherein the two different degrees of freedom are enabled by the kinematic coupling or by use of a second kinematic coupling; and optionally
causing adjustment of the retaining member against a resilient member disposed between the retaining member and the base unit, based on the kinematic coupling.
